# EUROPEAN PATENT APPLICATION

(11) **EP 4 357 297 A1**
(43) Date of publication of application: **24.04.2024**
(21) Application number: 22202853.2
(22) Date of filing: 20.10.2022
(51) Int. Cl.: B82Y 10/00, B82Y 40/00, C23C 14/00, G21K 1/00, H01J 37/317

(54) **PARTICLE TRANSFER APPARATUS AND METHODS**

(71) Applicant: ASML Netherlands B.V., 5500 AH Veldhoven (NL)
(72) Inventor: BEUKMAN, Arjan, Johannes, Anton, 5500 AH Veldhoven (NL); PARAYIL VENUGOPALAN, Syam, 5500 AH Veldhoven (NL); AKBULUT, Duygu, 5500 AH Veldhoven (NL); DE JAGER, Pieter, Willem, Herman, 5500 AH Veldhoven (NL)
(74) Representative: ASML Netherlands B.V.

(57) **Abstract**

A particle transfer system, including: a particle trap apparatus configured to trap a plurality of particles; and a particle conveyance structure configured to convey the particles in parallel from the particle trap apparatus to a substrate.

In an aspect, the particle transfer system is included in a patterning system for generating a pattern on a substrate.

## Description

### FIELD

The present description relates to methods and apparatus for applying particles to substrates in, for example, a device manufacturing process.

### BACKGROUND

A patterning apparatus (such as an optical lithographic apparatus) is a machine that applies a desired pattern onto a substrate, usually onto a target portion of the substrate. A patterning apparatus can be used, for example, in the manufacture of devices, such as integrated circuits (ICs). In that instance, a patterning device may be used in generating a device pattern to be formed on an individual layer of the device. This pattern can be transferred onto a target portion (e.g. comprising part of, one, or several dies) on a substrate (e.g. a silicon wafer). Often, transfer of the pattern is via imaging onto a layer of radiation-sensitive material (resist) provided on the substrate. In general, a single substrate will contain a network of adjacent target portions that are successively patterned. Known patterning apparatuses include so-called steppers, in which each target portion is patterned with an entire pattern onto the target portion at one time, and so-called scanners, in which each target portion is patterned by scanning the pattern in a given direction (the "scanning"-direction) while synchronously scanning the substrate parallel or anti-parallel to this direction. It is also possible to transfer the pattern from the patterning device to the substrate by imprinting the pattern onto the substrate.

### SUMMARY

It would be desirable to, for example, improve patterning apparatuses, related manufacturing apparatuses, and methods of manufacture of devices.

In an aspect, there is provided a particle transfer system, comprising:
a particle trap apparatus configured to trap a plurality of particles; and
a particle conveyance structure configured to convey the particles in parallel from the particle trap apparatus to a substrate

In an aspect, there is provided a patterning system for generating a pattern on a substrate, the system comprising:
a particle trap apparatus configured to trap a plurality of particles in a spatial arrangement; and
a particle conveyance structure configured to convey the particles in the form of a pattern from the particle trap apparatus to the substrate.

In an aspect, there is provided a particle transfer system, comprising:
a particle source configured to provide particles;
a particle cooling apparatus configured to cool the particles;
a particle trap apparatus configured to illuminate a plurality of spatial locations to locally trap single particles; and
a particle conveyance apparatus configured to convey the charged particles to a substrate surface.

In an aspect, there is provided a particle transfer system, comprising:
a particle source configured to provide particles;
a particle trap apparatus configured to generate a plurality of electric fields, each field at different spatial location and each field configured to locally trap a single particle;
a particle cooling apparatus configured to cool the particles; and
a particle conveyance apparatus configured to convey the charged particles to a substrate surface.

In an aspect, there is provided a computer program comprising program instructions operable to perform a method as described herein when run on a suitable apparatus.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example, with reference to the accompanying drawings in which:
Figure 1 depicts an embodiment of a production facility for forming devices;
Figure 2 depicts a schematic system view of an embodiment of a particle transfer tool;
Figure 3A depicts an example embodiment of a highly schematic top view of an embodiment of an arrangement of traps of a particle transfer tool;
Figure 3B depicts a highly schematic, side view of an embodiment of a version of a magneto-optical trap (MOT) of a particle transfer tool;
Figure 4 depicts a highly schematic, side view depiction of an example embodiment of an optical tweezer arrangement for a particle transfer tool;
Figure 5 depicts a high level breakdown of an embodiment of a particle transfer tool;
Figure 6 depicts a highly schematic side view of an embodiment of a particle transfer tool;
Figure 7 depicts a highly schematic side view of an embodiment of a particle transfer tool;
Figure 8 depicts a schematic top view of an embodiment of particle traps of an example particle trap apparatus of a particle transfer tool;
Figure 9A shows a schematic top view of an embodiment of an individual trap from Figure 8;
Figure 9B shows a schematic side view of the trap of Figure 9A along line A-A;
Figure 10 shows a schematic top view of an embodiment of a particle cooling structure of a particle transfer tool;
Figure 11 shows a schematic top view of an embodiment of a particle localization structure of a particle transfer tool;
Figure 12 shows an example simulation of an electric field of an embodiment of a trap across a cross-sectional width of the trap;
Figure 13 shows an example simulation of pondermotive potential of a portion of the electric field of Figure 12;
Figure 14A shows a schematic side view of an embodiment of a wire grid trap array arrangement of a particle transfer tool;
Figure 14B shows a schematic top view of an electrode from Figure 14A;
Figure 14C shows a schematic top view of electrodes from Figure 14A;
Figure 14D shows a schematic top view of an electrode from Figure 14A;
Figure 15 shows an example simulation of an electric field of an embodiment of a trap across a cross-sectional width of the trap;
Figure 16 depicts a schematic top view of a part of a particle transfer apparatus according to an embodiment;
Figure 17 depicts a schematic top view of a part of a particle transfer apparatus according to an embodiment;
Figure 18 depicts a highly schematic top view of an arrangement of individually addressable elements 102 is depicted in relation to a substrate W; and
Figure 19 illustrates schematically a top view of how a pattern or other layout may be generated on a substrate.

### DETAILED DESCRIPTION

Before describing embodiments of the invention in detail, it is instructive to present an example environment in which embodiments of the present invention may be implemented.

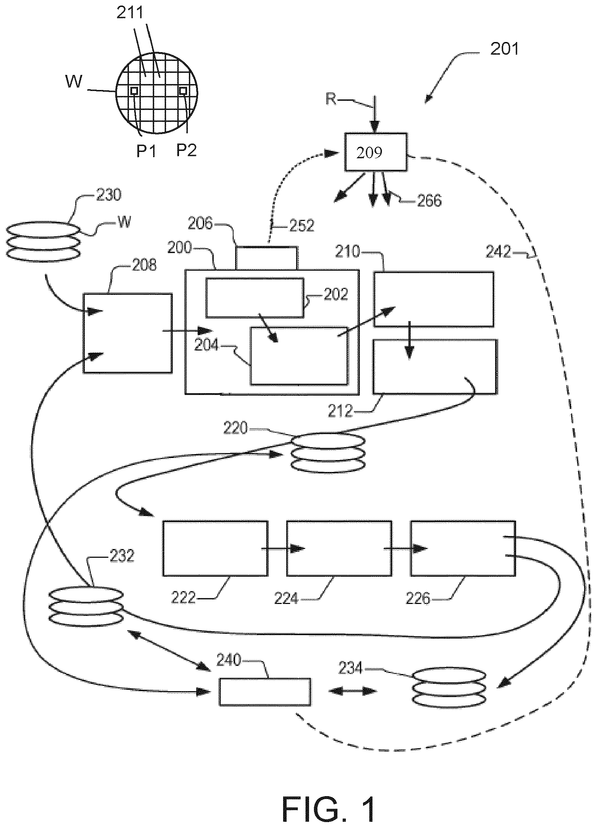

Figure 1 at 200 shows an apparatus as part of an industrial production facility implementing a high-volume manufacturing process. In the present example, the manufacturing process is adapted for the manufacture of, for example, devices (such as semiconductor products, e.g., ICs) on substrates 230 such as semiconductor wafers W. The skilled person will appreciate that a wide variety of products can be manufactured by processing different types of substrates in variants of this process and apparatus. The production of semiconductor products is used purely as an example which has great commercial significance today.

In this manufacturing process, one or more patterns are applied to a substrate in the aid of forming, e.g., a device. One such tool to apply a pattern is patterning apparatus 200. Within the patterning apparatus 200, a patterning station 204 is provided. Optionally, to aid throughput, a measurement station 202 can be provided. A control unit 206 is also shown. In this example, each substrate visits the measurement station and visits the patterning station to have a pattern applied. In an optical lithographic patterning apparatus, for example, a projection system is used to transfer a product pattern onto the substrate using conditioned radiation and a projection system. This is done by forming an image of the pattern in a layer of radiation-sensitive resist material. In an imprint patterning apparatus, an imprint template is used to apply a pattern by physical contact between the template and the substrate.

Well-known modes of operation of a patterning system include a stepping mode and a scanning mode as described above. The stepping mode can also include multiple patterning of a same target portion in adjacent or overlapping applications of a same or (typically) different pattern, which mode of operation sometimes may require stitching depending on the accuracy of the placement of the patterns. As is well known, the patterning system may cooperate with support and positioning systems for the substrate and the device used to apply the pattern in a variety of ways to apply a desired pattern to many target portions 211 across a substrate W.

The control unit 206 which controls all the movements and measurements of various actuators and sensors to receive substrates W and to implement the patterning operations. The control unit 206 also includes signal processing and data processing capacity to implement desired calculations relevant to the operation of the apparatus. In practice, control unit 206 will be realized as a system of many sub-units, each handling the real-time data acquisition, processing and control of a subsystem or component within the apparatus.

Before the pattern is applied to a substrate at the patterning station, the substrate is processed in at the measurement station 202 so that various preparatory steps may be carried out. The preparatory steps may include mapping the surface height of the substrate using a level sensor and measuring the position of alignment marks (e.g., marks PI, P2 and typically many such other such marks - often in scribe lanes but additionally or alternatively in the target portions) on the substrate using an alignment sensor. The alignment marks are arranged nominally in a regular grid pattern. However, due to inaccuracies in creating the marks and also due to deformations of the substrate that occur throughout its processing, the marks deviate from the ideal grid. Consequently, in addition to measuring position and orientation of the substrate, the alignment sensor in practice must measure in detail the positions of many marks across the substrate area, if the apparatus is to form product features at the correct locations with very high accuracy. The apparatus may be of a so-called dual stage type which has two substrate tables, each with a positioning system controlled by the control unit 206. While one substrate on one substrate table is being patterned at the patterning station 204, another substrate can be loaded onto the other substrate table at the measurement station 202 so that various preparatory steps may be carried out. The measurement of alignment marks is therefore very time-consuming and the provision of two substrate tables enables a substantial increase in the throughput of the apparatus. The patterning apparatus 200 may be, for example, a so-called dual stage type which has two substrate tables and two stations - a patterning station and a measurement station- between which the substrate tables can be exchanged. Or the patterning apparatus 200 may have a substrate table and another table for doing preparatory work, such as measurements, and the substrate table can be moved to and away from the patterning station and similarly the other table can be moved to and away from the patterning station so that the substrate table and the other table can share the patterning station.

Within the production facility, apparatus 200 forms part of a "litho cell" or "litho cluster" 201 that also contains a coating apparatus 208 for applying a layer (such as a photosensitive resist and/or other coating) to substrates W for patterning by the apparatus 200. At an output side of apparatus 200, a baking apparatus 210 and/or developing apparatus 212 can be provided for developing the formed pattern into a more fixed state. Between all of these apparatuses, substrate handling systems take care of supporting the substrates and transferring them from one piece of apparatus to the next. These apparatuses, which are often collectively referred to as the track, are under the control of a track control unit which is itself controlled by a supervisory control system 209, which also provide information (e.g., for control, adjustment, etc.) 266 to the apparatus 200 via control unit 206 and/or information (e.g., for control, adjustment, etc.) 266 to one or more other apparatuses (e.g., 222, 224, 226, 208, 210, 212, etc.) in the litho cell. Thus, the different apparatus can be operated to maximize throughput and processing efficiency. Supervisory control system 209 receives recipe information R which provides in great detail a definition of the steps to be performed to create each patterned substrate and/or receives information 252 (e.g., measurement information) from the apparatus 200 via unit 206.

Once the pattern has been applied and developed in the litho cell, patterned substrates 220 are transferred to other processing apparatuses such as are illustrated at 222, 224, 226. A wide range of processing steps is implemented by various apparatuses in a typical manufacturing facility. For the sake of example, apparatus 222 in this embodiment is an etching station, and apparatus 224 performs a deposition or implantation step. Further physical and/or chemical processing steps are applied in further apparatuses, 226, etc. Numerous types of operation can be required to make a real device, such as deposition of material, modification of surface material characteristics (oxidation, doping, ion implantation etc.), chemical-mechanical polishing (CMP), and so forth. The apparatus 226 may, in practice, represent a series of different processing steps performed in one or more apparatuses. As another example, apparatus and processing steps may be provided for the implementation of self-aligned multiple patterning, to produce multiple smaller features based on a precursor pattern laid down by the apparatus 200.

As is well known, the manufacture of semiconductor devices involves many repetitions of such processing, to build up device structures with appropriate materials and patterns, layer-by-layer on the substrate. Accordingly, substrates 230 arriving at the litho cluster may be newly prepared substrates, or they may be substrates that have been processed previously in this cluster or in another apparatus entirely. Similarly, depending on the required processing, substrates 232 on leaving apparatus 226 may be returned for a subsequent patterning operation in the same litho cluster, they may be destined for patterning operations in a different cluster, or they may be finished products to be sent for dicing and packaging.

Each layer of the product structure requires a different set of process steps, and the apparatuses 226 used at each layer may be completely different in type. Further, even where the processing steps to be applied by the apparatus 226 are nominally the same, in a large facility, there may be several supposedly identical machines working in parallel to perform the step 226 on different substrates. Small differences in set-up or faults between these machines can mean that they influence different substrates in different ways. Even steps that are relatively common to each layer, such as etching (apparatus 222) may be implemented by several etching apparatuses that are nominally identical but working in parallel to maximize throughput. In practice, moreover, different layers require different etch processes, for example chemical etches, plasma etches, according to the details of the material to be etched, and special requirements such as, for example, anisotropic etching.

The previous and/or subsequent processes may be performed in other patterning apparatuses, as just mentioned, and may even be performed in different types of patterning apparatus. For example, some layers in the device manufacturing process which are very demanding in parameters such as resolution and overlay may be performed in a more advanced patterning tool than other layers that are less demanding. Therefore some layers may be exposed in an immersion type lithography tool, while others are exposed in a different patterning tool (e.g., a 'dry' tool). Some layers may be exposed in a tool working at DUV wavelengths, while others are exposed using EUV wavelength radiation.

In order that the substrates that are exposed by the apparatus 200 are patterned correctly and consistently, it is desirable to inspect patterned substrates to measure properties such as overlay errors between subsequent layers, line thicknesses, critical dimensions (CD), etc. Accordingly a manufacturing facility in which litho cell 201 is located also includes a metrology system 240 which receives some or all of the substrates 234 that have been processed in the litho cell. So, in order to monitor the patterning process, one or more parameters of the patterned substrate are measured. Such one or more parameters may include, for example, the overlay error between successive layers formed in or on the patterned substrate and/or critical linewidth (CD) of features formed on the substrate. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Metrology results 242 are provided directly or indirectly to the supervisory control system 209. If errors are detected, adjustments may be made to patterning of one or more subsequent substrates (or of further patterning of one or more measured substrates), especially if the metrology can be done soon and fast enough that substrates of the same batch are still to be patterned. Also, already patterned substrates may be stripped and reworked to improve yield, or discarded, thereby avoiding performing further processing on substrates that are known to be faulty. In a case where only some target portions of a substrate are faulty, further patterning can be performed only on those target portions which are good.

Traditionally, formation of patterns on a substrate to create devices, such as ICs, has been done using various familiar technologies like optical lithography, imprint lithography, electron beam writing, etc. Such technologies usually do so via an intermediate resist layer. These resists are commonly composed of molecules (far larger than atoms) and therefore are not able to reach atomic resolution (<nm). Moreover, even attaining resolution at the single molecule or several molecule size is impossible or difficult in view of the constraints imposed by the applicable technology, such as the wavelength of radiation in optical lithography, the size of imprint features of an imprint template, the stochastic nature of particle beam writing, etc.

Similarly, other techniques part of a patterning process (sputtering, evaporating, implanting, atomic layer deposition (ALD), chemical vapor deposition (CVD), etc.) are used apply particles (e.g., atoms, molecules, etc.) to the substrate. However, these techniques typically apply to the whole substrate and often do not have any or much lateral resolution (certainly not spatial atomic resolution). For example, ion implanting typically has a great deal of spread and lack of spatial resolution, such as 30 nm or more spread in positioning or resolution due to straggle.

In other fields, arranging atoms or other particles on a substrate is the realm of scanning probe technologies (such as scanning-tunnelling microscopy (STM). Here, a very sharp mechanical tip is used to pick and place, or move, single atoms on the surface of a substrate. These technologies are very slow. Moreover, scanning-probe technologies are hard to scale-up in area as well as throughput. For example, a massive amounts of tips that move atoms in parallel could be used. However, it is cumbersome because many of them need to be controlled accurately and they need to be controlled individually or in small groups to realize various patterns.

Accordingly, there is a desire to have a particle transfer apparatus and process that is able to apply particles on a substrate at, e.g., 10 nm or less resolution (e.g., feature spacing, feature size, or maximum distance from a design location), or at 5 nm or less resolution, or at 1 nm or less resolution, or at 0.5 nm or less resolution (or any other range selected from the range of 10 nm or less). So, there is provided herein a scalable system to transfer single, or clusters of, particles (e.g., atoms and whether neutral or ions) to a substrate in the form of, for example, a pattern with the above described positioning accuracy (desirably sub-nanometer (Angstrom) positioning accuracy).

Possible applications of such a system are diverse, and can include:
- Deposition of a plurality of single particles or of clusters of particles at the above-described resolution in, for example, an arbitrary pattern. In principle, one can build devices from the ground-up (including mixing various particles, e.g., atoms, molecules, etc.).
- Deterministic implantation of particles with the above-described resolution in, for example, a pattern. For instance, donors in CMOS, or defects for quantum computing (NV-centers, etc.).
- Etch with the above-described resolution in, for example, a pattern. For example, chemical etching using, e.g., a low-landing energy, where the particle(s) can chemically remove one or more particles at the location the deposited particle(s) reaches. Alternatively or additionally, the particle(s) can be given a sufficient kinetic energy such that the particle(s) sputters one or more particles away on the surface.

In an embodiment, to achieve this or other applications, there is provided a system that, in its general form, uses cold particles and particle traps in combination with a conveyance mechanism (e.g., electron optics and/or an electric charge) to convey the particles from the traps to the substrate.

In an embodiment, the system is configured to process neutral particles such as atoms, clusters of atoms, or molecules that are neutral. In an embodiment, the neutral particles are trapped. In an embodiment, a cooling and trapping apparatus is used to cool and contain the particles. The trapped particles are then conveyed to the substrate. In an embodiment, the conveyance comprises application of charge to (e.g., ionization of) the particles and charged particle optics are used to convey the ionized particles to the substrate. To achieve throughput and scale, a large number of traps are used and the particles can be conveyed effectively in parallel to the substrate from the traps.

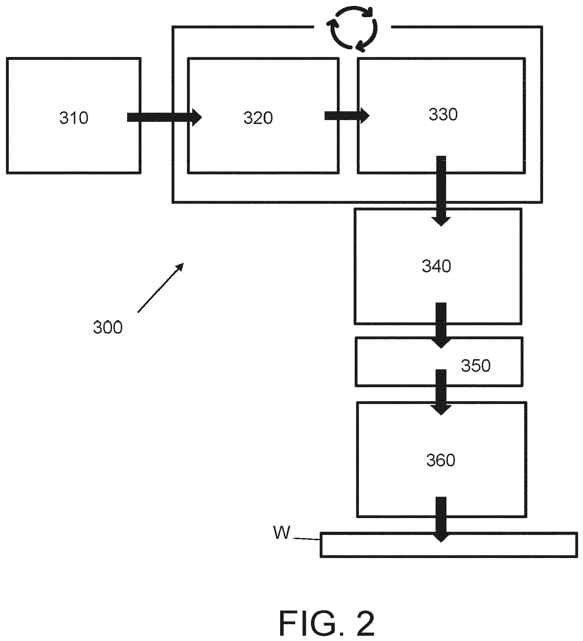

Referring to Figure 2, a high level breakdown of an embodiment of the system 300 is depicted. In short, in the system, particles are cooled (such that they have ultra-low energy spread) and localized using traps (e.g., atom traps). This allows the particles to then be conveyed (e.g., softly deposited) on the substrate with high accuracy using, for example, charged particle optics. Since the system operates at a particle level, the system (or at least the part that conveys the particles to the substrate through the space between the physical tool and the substrate) should be under low pressure (likely ultra-high vacuum) to avoid any (to-be conveyed) particle collisions with background gas particles.

A particle source 310 generates a particle stream or cloud. For example, the particle source 310 releases particles (e.g., atoms) from a solid or liquid into a particle stream or cloud or releases the particles directly from a gas storage. Such a source is commonly used in thermal or e-beam evaporators and/or sputter tools and a source designed for such applications can be configured to be used in this system. In an embodiment, the particle source 310 is a single atom source. The temperatures of the particles at this stage can be at or above room temperature (T>300K). The beam can be scanned across a particle cooling structure 320 (which may include a plurality of traps as described herein).

The particle output of the particle source 310 is received at a particle cooling structure 320. The particle cooling structure 320 cools the received particle flux down sufficiently such that the particles can be trapped in a particle trap. In an embodiment, temperatures should be less or equal to 1000 mK, less than or equal to 100 mK, less than or equal to 10 mK, or less than or equal to about 1 mK (or any other range selected from the range of less than 1000 mK) in order to enable the particles to be appropriately trapped. Cooling can be done in various stages, e.g., cooled to a certain a temperature and then cooled to a further lower temperature. In an embodiment, cooling in stages can use different types of apparatus, use multiple instances of the same type of apparatus, use different applications of a cooling in a same apparatus, or any combination selected therefrom. In an embodiment, the cooling can be performed by laser cooling (Doppler cooling) apparatus as known in the art and configured or modified for use in the system described herein. In an embodiment, the cooling can be performed by a Zeeman slower as known in the art and configured or modified for use in the system described herein. In an embodiment, the cooling can be performed by Sisyphus cooling apparatus as known in the art and configured or modified for use in the system described herein. In an embodiment, the cooling can be performed by cavity cooling apparatus as known in the art and configured or modified for use in the system described herein. In an embodiment, the cooling can be performed by optical molasses cooling apparatus as known in the art and configured or modified for use in the system described herein.

The cooled particles are then trapped by a particle trap apparatus 330 to localize one or more particles in a volume or area. In an embodiment, the trap apparatus localizes a plurality of particles each in a different one of a plurality of volumes or areas, each such volume or area is referred to herein as a trap. In an embodiment, any particle trap apparatus can be used. In an embodiment, the particle trap apparatus is configured and operated to localize a single particle in each trap. A trap may initially have a plurality of particles but then may be manipulated to realize a single particle in each trap. In particular, to help ensure 'deterministic' transfer, in an embodiment, a trap should only allow one particle inside. This can be achieved by tuning confinement potential such that only one can sit inside, and Coulomb energy is higher than the trap. To aid this, the particles may be ionized, e.g., using laser radiation.

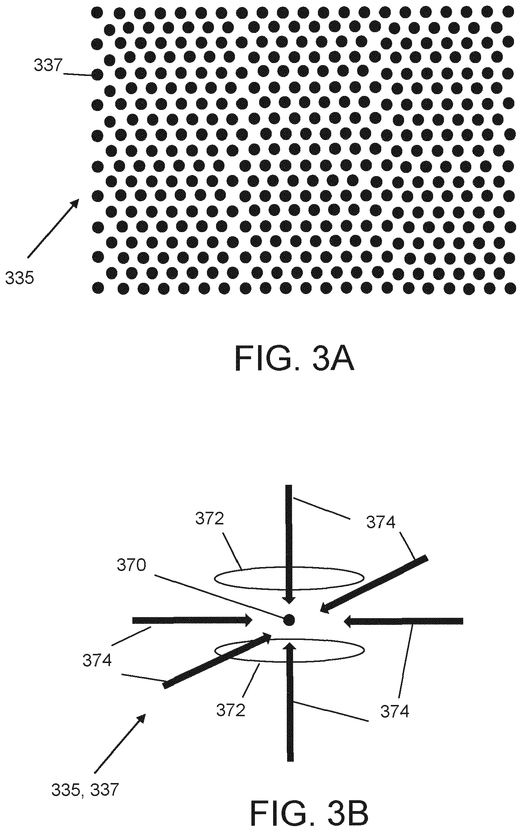

In an embodiment, referring to Figure 3A, an example embodiment of a top view of an arrangement 335 of traps is shown comprising a plurality of traps 337. In an embodiment, the traps are arranged in a regular array however they need not be. In an embodiment, there can be more than or equal to 10 traps, more than or equal to 100 traps, more than or equal to 500 traps, more than or equal to 1000 traps, more than or equal to 10,000 traps, more than or equal to 100,000 traps, or more than or equal to 1,000,000 traps (or any other range selected from the range of more than or equal to 10 traps). As a non-limiting example, there may be 10,000 × 10,000 array of traps which may be located in, e.g., a 4 mm² area. As a non-limiting example, the traps can be spaced a distance selected from 10 nm - 20 microns apart, from 50 nm - 10 microns apart, from 75 nm - 1 micron apart, 100-500 nm apart, 100-300 nm apart, 50-300 nm apart, 50-200 nm apart, 75-125 nm apart, or any other range selected from 10 nm - 20 microns apart.

As discussed above, any particle trap apparatus, now known or known in the future, can be used. An example particle trap apparatus for neutral particles is a magneto-optical trap (MOT) apparatus as known in the art, which uses a combination of magnetic field and laser radiation to trap particles. In an embodiment, the magneto-optical trap is a 2D MOT. In an embodiment, the magneto-optical trap is a 3D MOT. A highly schematic, side view of an embodiment of a version of a MOT that can be used to create arrangement 335 and a trap 337 is shown in Figure 3B. A particle 370 is trapped using a pair of magnetic coils 372 in an anti-Helmholtz configuration and laser beams 374 directed at the particle 370 from different directions. As will be appreciated, the coils 372 and beams 374 (more than those shown obviously) can be used to form a plurality of traps 337 or a plurality of iterations of the coils 372 and beams 374 can be provided to form the plurality of traps 337. In an embodiment, the beam of particles can be scanned across the trap arrangement 335 to aid populating the traps.

The trapping at 335 can be referred to a reservoir trap as the confinement of each particle to its particular area or volume results in a relatively coarse location placement compared to a desired location placement to enable accurate placement of the particles for the transfer to the substrate. When the particles are trapped, they can be cooled even further using one or more different cooling techniques known in the art (e.g., optical molasses, Sisyphus cooling, etc.), including by the particle cooling structure 320. Thus, as shown in Figure 2, the cooling at 320 and trapping at 330 can be repeated until a desired relatively coarse location placement is achieved. Optionally, a 2D trap ('pancake trap') is created by using a strong laser, which confines particles in a 2D plane.

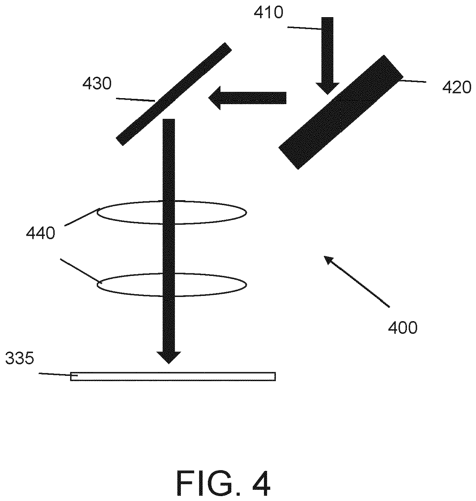

Once the particles are sufficiently trapped at 330, in an embodiment, the particles are further locally trapped using a particle localization structure 340. In an embodiment, the particle localization structure 340 comprises optical tweezers. In an embodiment, such locals traps are created by laser spots in the 2D plane. These laser spots are called optical tweezers and can trap particles (e.g., single particles) at a well-defined spatial location. By tuning where the spots occur a pattern of particles can be created. Referring to Figure 4, a highly schematic, side view depiction of an example embodiment of an optical tweezer arrangement 400 is shown. A radiation beam 410 is processed by radiation modulator, such as a switchable mirror array (e.g., a digital mirror device (DMD)), an acousto-optic tunable filter (AOTF), another type of any other type of spatial light modulator (SLM), etc. so as to create radiation spots at different locations within the array of traps 335 and to be able to control their position and/or whether a spot is on or off. The result is that a pattern of spots can be created, which can then create the pattern of particles for subsequent conveyance to the substrate. Each of the spots is thus akin to a pixel and the associated one or more particles of a spot are used to transfer an associated particle to the substrate as effectively a pixel at the substrate. Similarly, a plurality of spots can be akin to a pixel and the associated particles of that plurality of spots are used to transfer the associated particles to the substrate as effectively a pixel at the substrate. The spots are directed by an optional mirror 430 to optional optics 440 which provide the spots to the array of traps 335. The resulting optical tweezer traps arising from the spots have widths in the order of the wavelength of radiation used, e.g., in the range of the 0.5 to 2 microns depending on radiation wavelength (where the width is approximately proportional to the wavelength divided by the numerical aperture of the optics 440. A cold particle trapped in each such optical tweezer can have a confinement far less than the trap width, approximately 10 times smaller than the optical tweezer trap width, because its energy is much lower than the potential well. In an embodiment, the confinement is selected from the range of 0.1 to 150 nm, e.g., selected from the range of 0.1 to 100 nm such as selected from the range of 1 to 100 nm, such as selected from the range of 0.1 to 50 nm, such as selected from the range of 50 to 110 nm (or any other range selected from the range of 0.1 to 150 nm). In an embodiment, optical tweezer arrangement 400 provides a strong confinement to localize a particle to a location of less than or equal to 50 nm of a desired position, to a location of less than or equal to 30 nm of a desired position, to a location of less than or equal to 20 nm of a desired position, to a location of less than or equal to 10 nm of a desired position, or to a location of less than or equal to 5 nm of a desired position, to a location of less than or equal to 2 nm of a desired position, or to a location of less than or equal to 1 nm of a desired position (or any other range selected from the range of less than or equal to 50 nm). In an embodiment, alternatively or additionally to the optical tweezer arrangement discussed above, any other local trapping mechanism can be used to further locally trap particles. In an embodiment, the local trapping mechanism is configured to trap neutral particles. In an embodiment, as an example, particles may be charged at the traps (e.g., using a laser as described herein) and then further locally trapped using, for example, a Paul trap or wire grid array as described herein.

With the particles localized, they are then conveyed by a particle conveyance apparatus 360 to the substrate W. That is, the particles are conveyed from traps at 340 to the substrate W. In an embodiment, the particle conveyance apparatus 360 is configured to transfer neutral particles in a relatively deterministic manner from the trap to the substrate W. For example, a laser beam can be shone onto a trapped particle, e.g., from the top of the traps shown in Figure 3A. When the laser is tuned to a transition inside the neutral particle and shines from one direction, the beam can effectively 'push' the particle away from the trap along the laser beam direction toward the substrate. In an embodiment, there can be a single or a plurality of laser beams provided by a single or a plurality of laser beam sources shone onto the plurality of traps (having the plurality of particles). In an embodiment, the local traps enabled by the optical tweezers are turned off and the particles are displaced to the substrate using the one or more beams.

In an embodiment, the substrate W may be sufficiently close to the traps at 340 such that an electric charge (e.g., a DC pulse) between the substrate W and the traps at 340 can enable the particles to be conveyed from there to the substrate. Thus, the particle conveyance apparatus 360 can be one or more electrodes connected to an appropriate power source to provide the electric charge. In an embodiment, the local traps enabled by the optical tweezers are turned off and the particles are displaced to the substrate using the charge.

In an embodiment, to help achieve desired placement specifications in, for example, the range of 0.1 nm to 4 nm, the range of 0.1 nm to 2 nm or the range of 0.1 to 1 nm and/or to allow extra space between the traps and the substrate, optics can be used to convey the particles to the substrate. In an embodiment, the particle conveyance apparatus 360 comprises charged particle optics. For example, an electrostatic lens known in the art, such as used in electron beam apparatuses, can be used. For example, the charged particle optics comprises an Einzel lens.

In an embodiment, the particles are charged by particle charge apparatus 350 (if the particles have not already been charged). In an embodiment, the particles are charged using laser radiation (e.g., ionization by laser irradiation). In an embodiment, charging of the particles enables the charged particle optics to work with neutral particles originally provided by source 310. Additionally or alternatively, the charging of the particles enables traps to hold a single particle and the inherent repelling nature of like charged particles would help force a particular particle out, or keep a particle from going into, a trap.

In an embodiment, particles are imaged onto the substrate with a de-magnification, particularly where, for example, the confinement using the particle localization structure is not in the desired placement specification. In an embodiment, the de-magnification is provided by charged particle optics. Thus, local traps enabled by the particle localization structure are turned off and the particles are displaced to the substrate using the charged particle optics while the positioning of the particles is demagnified. In an embodiment, the charged particles are accelerated towards the charged particle optics. For example, a de-magnification selected from the range of 2-10000x, or from the range of 2-1000x or from the range of 2-100x (or any range selected from the range of 2-10000x) may be applied.

In an embodiment, where, for example in the application of deposition of a plurality of single particles or of clusters of particles in a pattern or to a specific small or narrow area, the optics are designed such that the landing energy of the particles at the substrate is almost zero (but not entirely, in the order of 0.2-1000 meV). This low landing energy helps ensure the particles 'soft-land' on the surface, stay in place and do not scatter off their respective locations. In an embodiment, the landing energies should be lower than the migration energy of the particle over the surface. In an embodiment, the landing energy is less than or equal to that at approximately room temperature (k_{b}T ~ 25 meV), which can help ensure the particles stay in place. The low landing energy may result in significant aberrations in standard charge particle optics (e.g., chromatic and/or spherical aberrations). Accordingly, in an embodiment, the energy spread in the lateral direction (e.g., parallel to the substrate surface) can be reduced by localizing the particle before it enters the charged particle optics in order to reduce the aberrations. Thus, control of the energy spread of the particles and/or strong localization of the particles can enable reduced chromatic and/or spherical aberrations. Using the cooling described herein, the energy spread can be reduced and can also facilitate the localization using the traps and particle localization structure.

As would be appreciated, the apparatus to provide the functions described with respect to 310, 320, 330, 340, 350 and 360 can be combined in one apparatus or a combination of two or more different apparatuses by having, e.g., a MOT arrangement with one or more additional lasers that shine into the MOT arrangement to provide cooling, the optical tweezers and/or the charging (e.g. ionization). Thus, the apparatus to provide 310, 320, 330, 340, 350 and 360 can have any type of physical construction or arrangement to provide those functions (e.g., they may all be integrated into a same apparatus, two or more functions integrated into one apparatus while one or more other functions are provided by a different apparatus, etc.). All of the apparatus 300 can be provided within a housing or chamber, which is typically arranged to be at low pressure. In an embodiment, one or more parts of the apparatus 300 can be provided outside of the housing or chamber. For example, in an embodiment, source 310 can be separate from the apparatus 320, 330, 340, 350 and 360 and then particles can be fed via a passage into the system corresponding to the apparatus 320, 330, 340, 350 and 360. One or more actuators can be provided to provide relative movement between the substrate W and the traps and/or optics, usually movement of the substrate W.

In a non-limiting embodiment, the system can have 100 DMDs of 2 MP each (e.g., in 10 × 10 array or a DMD having 200 MP), working in parallel with a frequency of around 50 kHz, so that the system can transfer particles with 0.5 nm or better accuracy at a throughput of 8h for a full standard 300 mm semiconductor substrate. Of course, use of larger clusters than single particles can increase throughput. Further, if only selected parts of the substrate require particles, then throughput can be increased.

In an embodiment, the system is configured to process charged particles such as atoms, clusters of atoms, or molecules that are charged. In an embodiment, the charged particles are trapped. In an embodiment, a cooling and trapping apparatus is used to cool and contain the particles. The trapped particles are then conveyed to the substrate. In an embodiment, the conveyance comprises use of charged particle optics to transfer the charged particles to the substrate. To achieve throughput and scale, a large number of traps are used and the particles can be conveyed effectively in parallel to the substrate from the traps. In an embodiment, each trap is able to capture a single charged particle and localize its positioning down to less than or equal to 1 nm, less than or equal to 10 nm, or less than or equal to 50 nm, or less than or equal to 100 nm (or any other range selected from the range of less than or equal to 100 nm) using cooling and strong confinement potential.

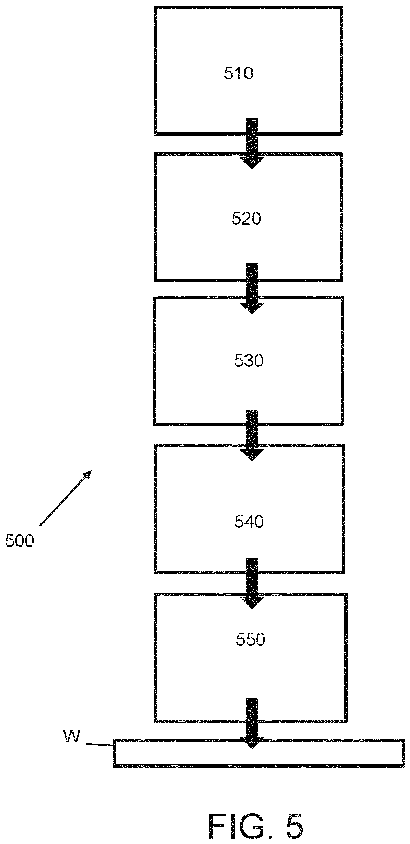

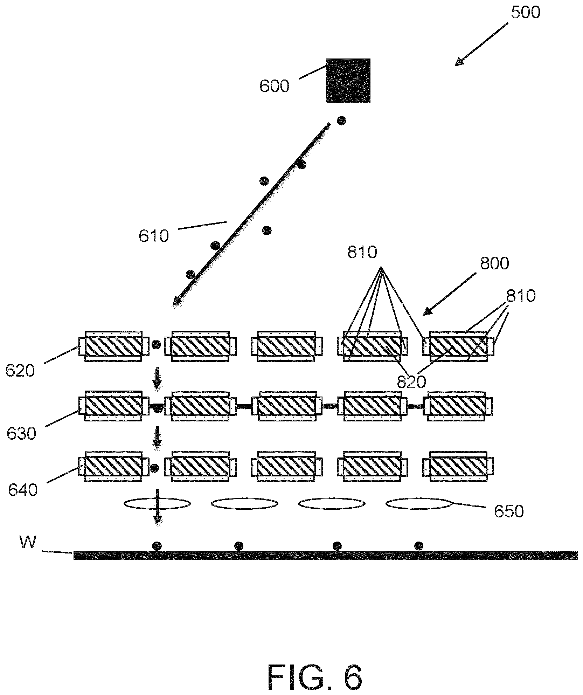

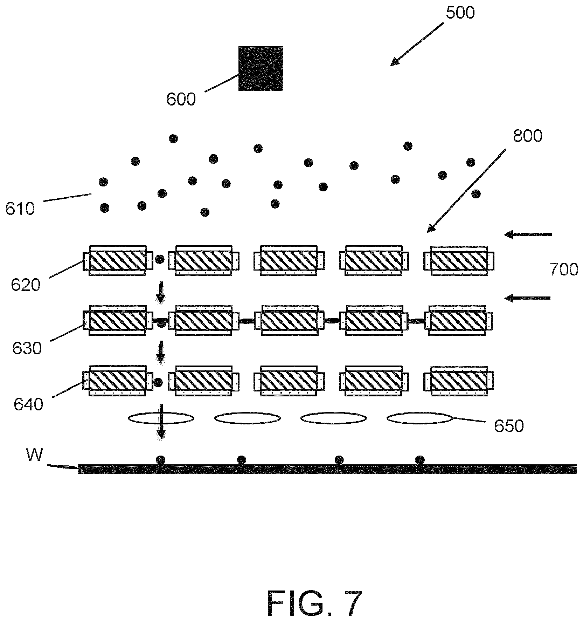

Referring to Figure 5, a high level breakdown of an embodiment of the system 500 is depicted. In short, in the system, particles are cooled (such that they have ultra-low energy spread) and localized using traps (e.g., atom traps). This allows the particles to then be conveyed (e.g., softly deposited) to the substrate with high accuracy using, for example, charged particle optics. Since the system operates at a particle level, the system (or at least the part that conveys the particles to the substrate through the space between the physical tool and the substrate) should be under low pressure (likely ultra-high vacuum) to avoid any (to-be conveyed) particle collisions with background gas particles. Figures 6 and 7 are schematic, side view depictions of an embodiment of the system according to Figure 5.

A particle source 510 generates a particle stream or cloud. For example, the particle source 510 releases particles (e.g., atoms) from a solid or liquid into a particle stream or cloud or releases the particles directly from a gas storage. Such a source is commonly used in thermal or e-beam evaporators and/or sputter tools and a source designed for such applications can be configured to be used in this system. In an embodiment, the particle source 510 is a single atom source. The temperatures of the particles at this stage can be at or above room temperature (T>300K). Referring to Figure 6, an embodiment of a particle source 600 outputs a beam (or cloud) of charged particles toward a particle trap apparatus 520, 620. In an embodiment, a beam of charged particles is scanned across the particle trap apparatus 520, 620 (which may include a plurality of traps as described herein). In a variant embodiment, referring to Figure 7, a particle source 600 outputs neutral particles in the form a cloud (or beam) toward a particle trap apparatus 520, 620. In an embodiment, a particle charge device 700 provides a charge to the particles. In an embodiment, the particle charge device 700 outputs one or more laser beams to provide the charge to the particles (e.g., ionization by irradiation). In an embodiment, a beam of neutral particles (which are then charged) is scanned across the particle trap apparatus 520, 620 (which may include a plurality of traps as described herein). So, a function of the source 510 arrangement is to populate the particle trap apparatus 520, 620 (e.g., all the traps of the particle trap apparatus 520, 620 with particles). If there are, e.g., 10,000 10,000 traps in a 4 mm² area (a trap around every 100 nm), then a scan speed of around 500 MHz should be sufficient. The duration per trap is such that multiple particles are fired toward the trap, to ensure a good probability that the trap is filled. In an embodiment, the particle stream has a current of ~1-10 uA.

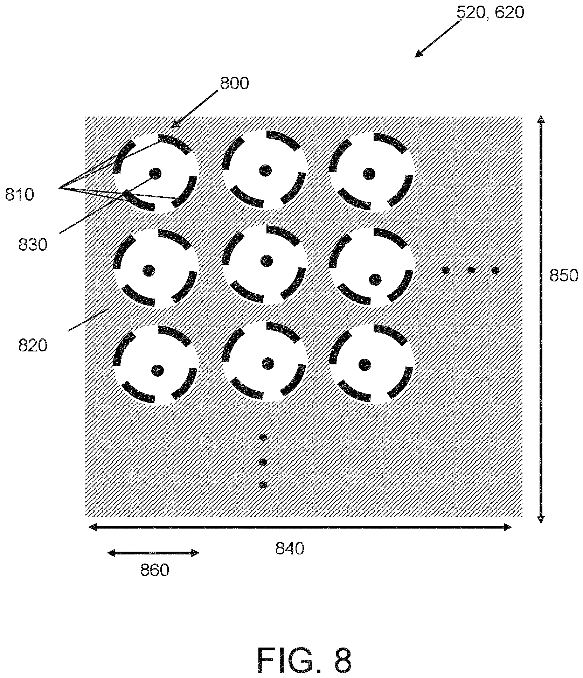

The particle output of the particle source 510 is received at a particle trap apparatus 520. An embodiment of the particle trap apparatus is schematically depicted as 620 in Figures 6 and 7. In an embodiment, the apparatus uses a plurality of charged particle traps. A schematic top view of an embodiment of the particle traps of a particle trap apparatus 520, 620 is presented in Figure 8. As discussed above, the plurality of charged particle traps can be populated with particles 830 by a beam or cloud particles.

The particle trap apparatus 520, 620 localizes one or more particles in a volume or area. In an embodiment, the trap apparatus localizes a plurality of particles each in a different one of a plurality of volumes or areas, each such volume or area is referred to herein as a trap. In an embodiment, the particle trap apparatus is configured and operated to localize a single particle in each trap. A trap may initially have a plurality of particles but then may be manipulated to realize a single particle in each trap. In particular, to help ensure 'deterministic' transfer, in an embodiment, a trap should only allow one particle inside. This can be achieved by tuning confinement potential such that only one can sit inside, and Coulomb energy is higher than the trap.

Referring to Figures 6-8, an example embodiment of arrangement of the traps is shown comprising a plurality of traps 800. In an embodiment, the traps are arranged in a regular array however they need not be. In an embodiment, there can be more than or equal to 10 traps, more than or equal to 100 traps, more than or equal to 500 traps, more than or equal to 1000 traps, more than or equal to 10,000 traps, more than or equal to 100,000 traps, or more than or equal to 1,000,000 traps (or any other range selected from the range of more than or equal to 10 traps). For example, there can be more than or equal to 1 trap, more than or equal to 5 traps, more than or equal to 10 traps, more than or equal to 100 traps, more than or equal to 200 traps, more than or equal to 500 traps, more than or equal to 1,000 traps, or more than or equal to 10,000 traps (or any other range selected from the range of more than or equal to 1 trap) along either or both directions 840 and 850. As a non-limiting example, there may be 10,000 × 10,000 array of traps which may be located in, e.g., a 4 mm² area. As a non-limiting example, the traps can be spaced a distance selected from 10 nm - 20 microns apart, from 50 nm - 10 microns apart, from 75 nm - 1 micron apart, 100-500 nm apart, 100-300 nm apart, 50-300 nm apart, 50-200 nm apart, 75-125 nm apart, or any other range selected from 10 nm - 20 microns apart. The trapping in the traps 800 can be referred to a reservoir trap as the confinement of each particle to its particular area or volume results in a relatively coarse location placement compared to a desired location placement to enable accurate placement of the particles to the substrate.

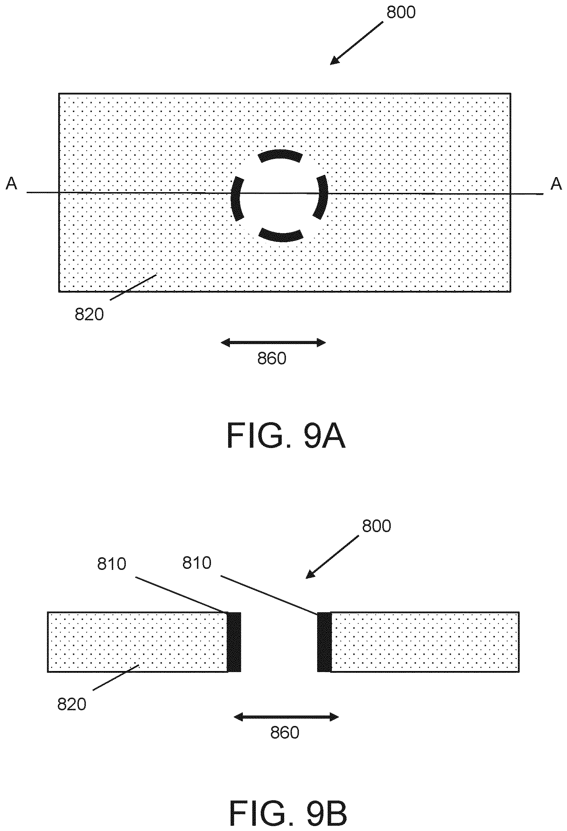

In an embodiment, any known particle trap apparatus can be used. In an embodiment, a particle trap 800 is configured to capture one or more charged particles (e.g., ions). In an embodiment, a particle trap 800 has multiple electrodes 810 housed on a body 820 (e.g., silicon body) on which electrodes RF and DC voltages are applied to generate at least an electric field, including, for example, a RF field. Figure 9A shows a schematic top view of an embodiment of an individual trap 800 from Figure 8 and Figure 9B shows a schematic side view of the trap 800 of Figure 9A along line A-A. In an embodiment, a charged particle trap comprises a Paul trap that includes a plurality of electrodes (e.g., at least 4 electrodes) which are pair-wise connected to a RF generator. The generated field forces a charged particle to a region of lowest field, which is typically designed to be a central portion of the trap. The trap potential can be parabolic or of higher order-type by choosing the arrangement of electrodes. In an embodiment, a controller is configured to provide the appropriate current/voltage to generate the trapping function, including, for example, generating a static and/or dynamic field. In an embodiment, the generated field is static. In an embodiment, the generated field is dynamic. In a preferred embodiment, the generated field is static and dynamic, e.g., comprises static and dynamic components. In an embodiment, the static field is a DC field. In an embodiment, the dynamic field is an AC or RF field.

In an embodiment, a function of a particle trap 800 is to deterministically capture a single particle from a stochastic beam or cloud of particles. So, in an embodiment, the trap 800 is appropriately configured (e.g., optimized) with a pertinent RF field amplitude and frequency such that only a single particle is trapped. If a second charged particle tries to populate the trap, it is repelled due to the Coulomb repulsion of the first particle. At the particle trap apparatus 520, 620, the one or more RF field parameters do not necessarily provide strong confinement. Shallow potential particle traps enable deterministic capture of single particles. The traps enable cooling of the captured particles.

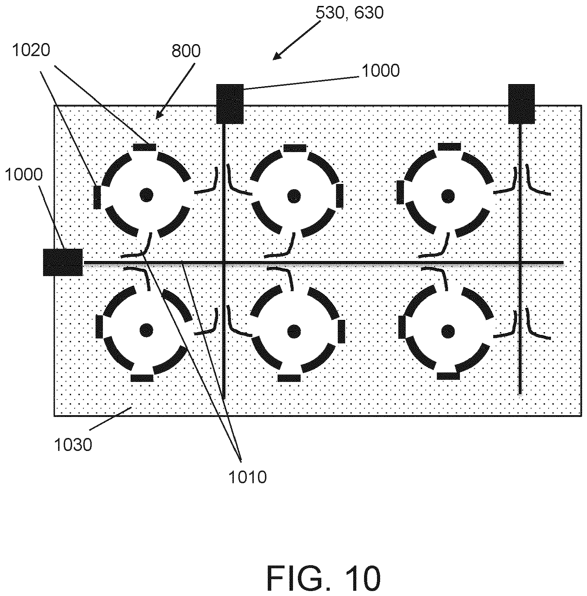

Referring to Figures 5-7 and 10, a particle cooling structure 530, 630 cools the received particle flux down sufficiently such that the particles can be strongly confined in a particle trap. Figure 10 shows a schematic top view of an example particle cooling structure 530, 630. In an embodiment, temperatures should be less or equal to 1000 mK, less than or equal to 100 mK, less than or equal to 10 mK, or less than or equal to about 1 mK (or any other range selected from the range of less than or equal to 1000 mK). Cooling can be done in various stages, e.g., cooled to a certain a temperature and then cooled to a further lower temperature. In an embodiment, cooling in stages can use different types of apparatus, use multiple instances of the same type of apparatus, use different applications of a cooling in a same apparatus, or any combination selected therefrom. In an embodiment, the cooling can be performed by laser cooling (Doppler cooling) apparatus as known in the art and configured or modified for use in the system described herein. In an embodiment, the cooling can be performed by a Zeeman slower as known in the art and configured or modified for use in the system described herein. In an embodiment, the cooling can be performed by Sisyphus cooling apparatus as known in the art and configured or modified for use in the system described herein. In an embodiment, the cooling can be performed by cavity cooling apparatus as known in the art and configured or modified for use in the system described herein. In an embodiment, the cooling can be performed by optical molasses cooling apparatus as known in the art and configured or modified for use in the system described herein.

Referring to Figure 10, an embodiment of particle cooling structure 530, 630 is depicted in association with a plurality of traps (which can have the structure as earlier depicted and described, see, e.g., Figures 6-9). In order to enable strong confinement, the particles should be cooled to at, or near to, the ground state of the potential well. Cooling is here performed using one or more lasers, e.g. Doppler cooling, Sisyphus cooling, cavity cooling, etc. Laser cooling takes advantage of trapped particles and so the particle cooling structure 530, 630 uses the traps 800 of particle trap apparatus 520, 620 or has its own traps (e.g., of the form of traps 800). In an embodiment, the radiation can reach the particles from above and/or below using free-space optics (not depicted in Figure 10). In an embodiment, the radiation can be supplied from one or more lasers 1000 (e.g., laser diodes) and supplied to the traps via one or more waveguides 1010 in, or on, a body 1030 housing the traps. One or more mirrors 1020 can be used to propagate the radiation from a waveguide that has propagated across a trap back through the trap. So, the mirrors mounted on the opposite side of the trap from the waveguide exits help photons impinge the particle from both sides. Additionally or alternatively, while not shown in Figures 8-10, one or more lasers can be used to shine radiation from above or below the body 820 onto the traps. Optionally, such an arrangement could use one or mirrors above or below the body 820 to work with the one or more lasers above or below the body 820 to reflect radiation back into the traps.

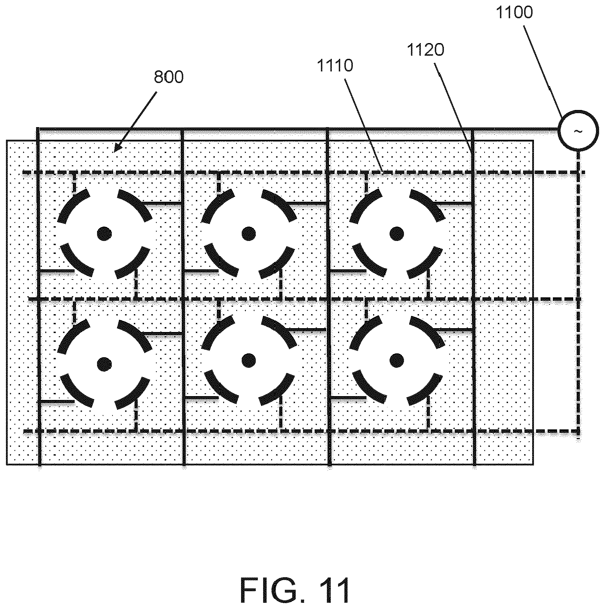

Once the particles are sufficiently cooled, in an embodiment, the particles are further locally confined using a particle localization structure 540, 640. Referring to Figures 5-7 and 11, an example embodiment of arrangement of a particle localization structure 540, 640 having a plurality of traps is depicted. Figure 11 shows a schematic top view of a particle localization structure 540, 640. In an embodiment, the traps are arranged in a regular array however they need not be. In an embodiment, there can be more than or equal to 10 traps, more than or equal to 100 traps, more than or equal to 500 traps, more than or equal to 1000 traps, more than or equal to 10,000 traps, more than or equal to 100,000 traps, or more than or equal to 1,000,000 traps (or any other range selected from the range of more than or equal to 10 traps). For example, there can be more than or equal to 1 trap, more than or equal to 5 traps, more than or equal to 10 traps, more than or equal to 100 traps, more than or equal to 200 traps, more than or equal to 500 traps, more than or equal to 1,000 traps, or more than or equal to 10,000 traps (or any other range selected from the range of more than or equal to 1 trap) along either or both of two different directions. As a non-limiting example, there may be 10,000 × 10,000 array of traps which may be located in, e.g., a 4 mm² area. As a non-limiting example, the traps can be spaced a distance selected from 10 nm - 20 microns apart, from 50 nm - 10 microns apart, from 75 nm - 1 micron apart, 100-500 nm apart, 100-300 nm apart, 50-300 nm apart, 50-200 nm apart, 75-125 nm apart, or any other range selected from 10 nm - 20 microns apart. As a non-limiting example, the traps can have a width selected from 50 nm - 10 microns, from 75 nm - 1 micron, 100-500 nm, 100-300 nm, 50-300 nm, 50-200 nm, 75-125 nm, or any other range selected from 10 nm - 20 microns.

In an embodiment, any known particle trap apparatus can be used. In an embodiment, a particle trap is configured to capture one or more charged particles (e.g., ions). In an embodiment, the particle trap can have the form of particle trap 800 as described previously. The electrodes of traps 800 can be connected to a RF voltage source 1100 via wires 1110 and 1120. In an embodiment, a charged particle trap comprises a Paul trap that includes a plurality of electrodes (e.g., at least 4 electrodes) which are pair-wise connected to a RF generator 1100. The RF field forces a charged particle to a region of lowest field value, which is typically designed to be a central portion of the trap. The trap potential can be parabolic or of higher order-type by choosing the arrangement of electrodes. So, in an embodiment, the trap is appropriately configured (e.g., optimized) with a pertinent RF field amplitude and frequency such that the particles(s) is confined to a very specific location (area or volume). In an embodiment, the traps of particle localization structure 540 provide a strong confinement to localize a respective particle(s) to a location of less than or equal to 100 nm of a desired position, to a location of less than or equal to 10 nm of a desired position, to a location of less than or equal to 5 nm of a desired position, to a location of less than or equal to 2 nm of a desired position, or to a location of less than or equal to 1 nm of a desired position.

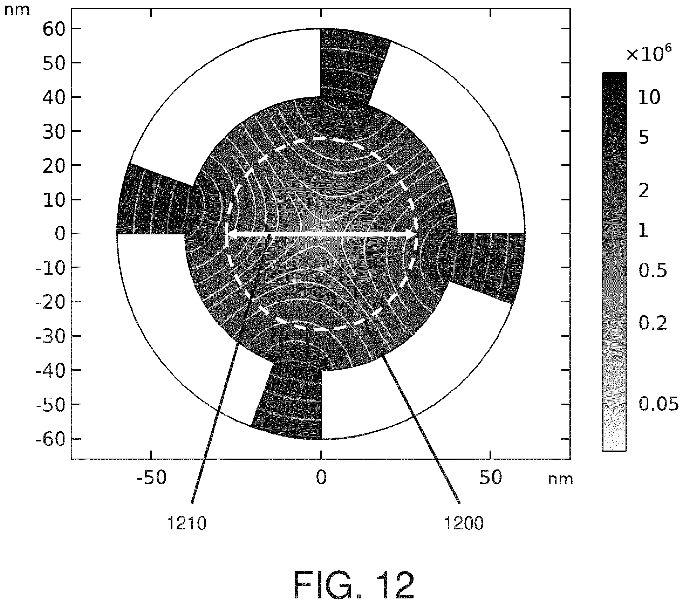

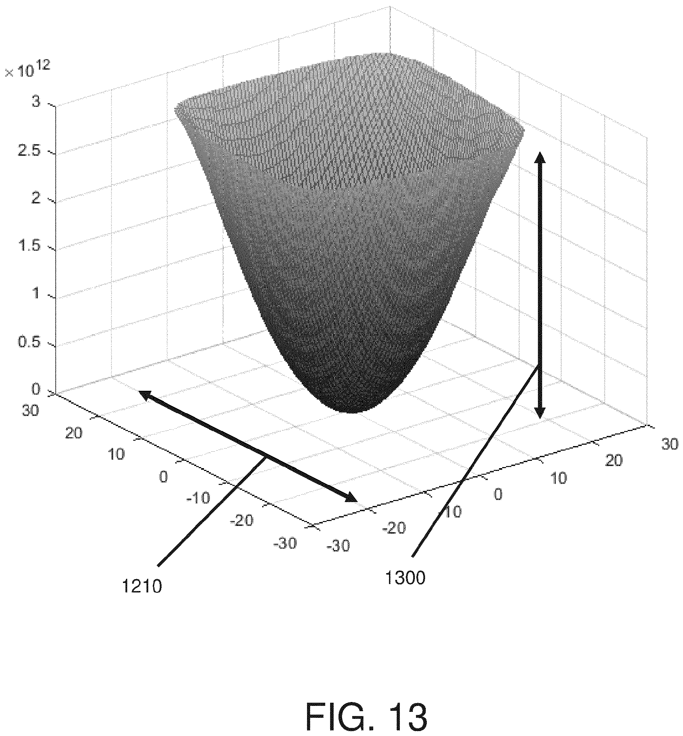

Figure 12 shows a simulation of an electric field of a trap 800 across a cross-sectional width of around 100 nm. In this case, the electric field is normalized and in units of V/m. As can be seen the voltage varies from the periphery to a lowest value near or at the central location in the trap 800. A particle will tend to be confined there due to the electric potential field. Figure 13 shows a simulation of the pondermotive potential of the portion 1200 of the electric field of Figure 12. The cross-sectional width 1210 across this portion is approximately 60 nm. As seen in Figure 13, a potential well is formed with a depth 1300. As can be seen, a particle will tend to be confined in the well due to the electric potential field of the trap 800.

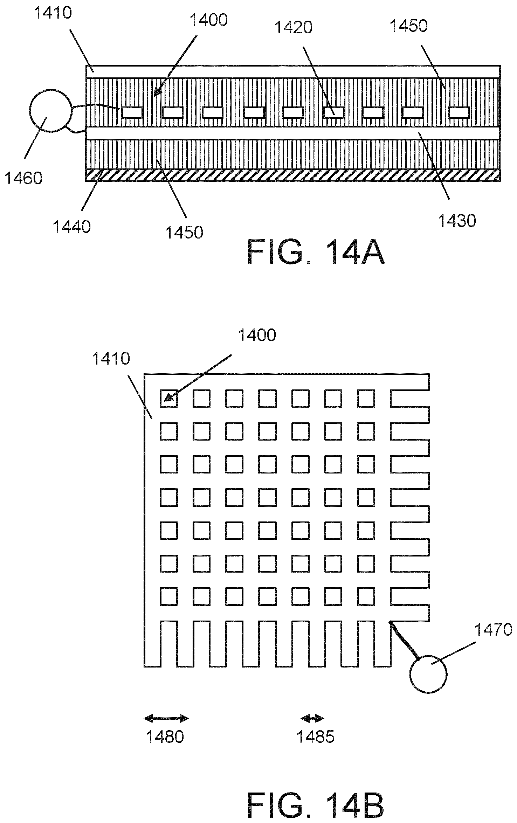

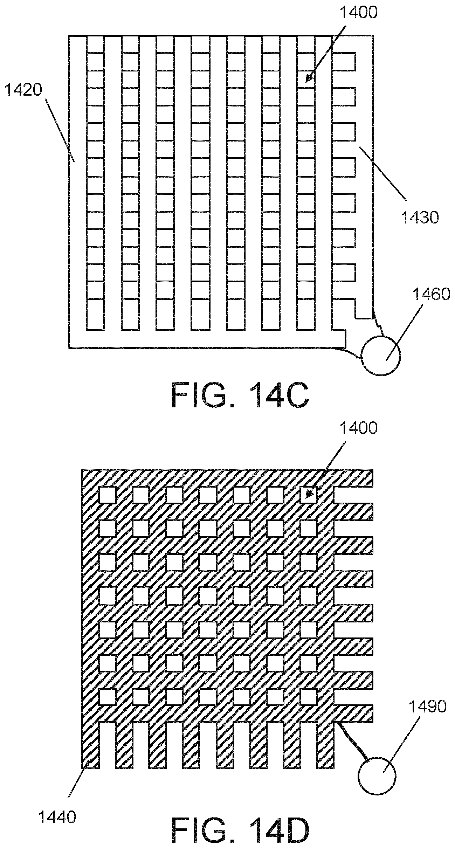

Figure 14 shows an embodiment of an array of particle traps 1400 using a wire grid arrangement. A particle trap 1400 can be used to provide strong localization of a particle(s). Figure 14A shows a schematic side view of a wire grid trap array arrangement. The wire grid array comprises a first electrode 1410 in the form, e.g., a grid structure, a second electrode 1420 in the form of, e.g., a comb-like structure, a third electrode 1430 in the form, e.g., a comb-like structure, and a fourth electrode 1440 in the form of, e.g., a grid structure. In an embodiment, a dielectric 1450 is provided between the electrodes to keep them isolated from each other; an open gap or other material than a dielectric could be used. An RF source 1460 is configured to provide RF voltage to the second electrode 1420 and the third electrode 1430 to generate a field in the gaps shown at least in Figure 14A within parts of the second electrode 1420 and to the gap between the second and third electrodes 1420, 1430.

Figure 14B shows a schematic top view of the first electrode 1410. As seen, a particle trap 1400 is formed at a hole in the first electrode 1410. A DC source 1470 is configured to provide DC voltage to the first electrode 1410. The holes in electrode 1410 allow particles to enter the wire grid trap array arrangement so as to become trapped in respective traps 1400. In an embodiment, the distance (pitch) 1480 is selected from the range of about 20 to 200 nm, the range of about 80 to 150 nm, the range of about 90 to 125 nm, or any range selected from the range of about 20 to 200 nm. In an embodiment, the width 1485 is selected from the range of about 5 to 100 nm, the range of about 10 to 70 nm, the range of about 15 to 50 nm, or any range selected from the range of about 5 to 100 nm.

Figure 14C shows a schematic top view of the second and third electrodes 1420, 1430. As seen, a particle trap 1400 is formed at a hole defined by the second and third electrodes 1420, 1430. A RF source 1460 is configured to provide RF voltage to the second and third electrodes 1420, 1430. The holes defined by the second and third electrodes 1420, 1430 allow particles to enter and enable trapping of the particles in respective traps 1400. The dielectric layer between the second and third electrodes 1420, 1430 is not shown in Figure 14C for ease of understanding.

Figure 14D shows a schematic top view of the fourth electrode 1440. As seen, a particle trap 1400 is formed at a hole in the fourth electrode 1440. A DC source 1490 is configured to provide DC voltage to the fourth electrode 1440. The holes in electrode 1440 allow particles to exit the respective traps 1400 of the wire grid trap array arrangement so as to be conveyed to a wafer (which is not shown but which would be, in an embodiment, below the wire grid array arrangement shown in Figure 14A).

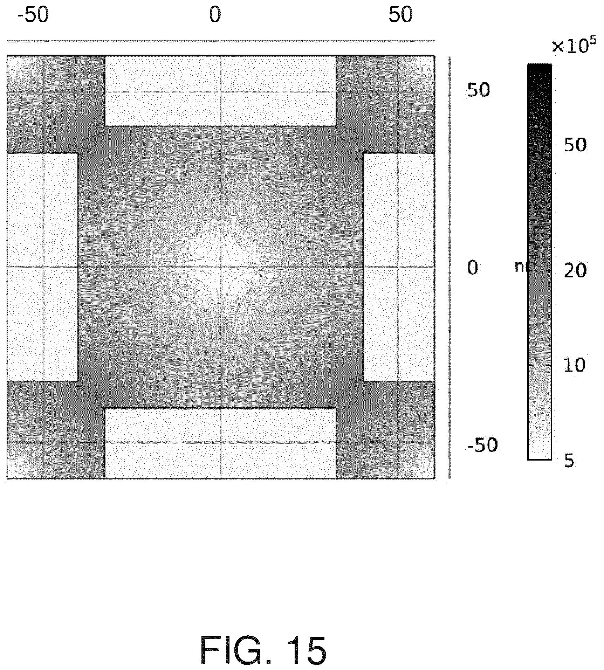

Figure 15 shows a simulation of an electric field of a trap comparable to trap 1400 across a cross-sectional width of around 100 nm. In this case, the electric field is normalized and in units of V/m. As can be seen the voltage varies from the periphery to a lowest value near or at the central location in the trap. A particle will tend to be confined there due to the electric potential field. As can be seen, the field is comparable to that of Figure 12.

With the particles localized, they are then conveyed by a particle conveyance apparatus 550 to the substrate W. That is, the particles are conveyed from traps at 540, 640, such as traps 800, 1400, to the substrate W. In an embodiment, the substrate W may be sufficiently close to the traps at 540, 640 that an electric charge (e.g., a DC pulse) between the substrate W and the traps at 540, 640 can enable the particles to be conveyed from the traps at 540, 640 to the substrate. Thus, the particle conveyance apparatus 550 can be one or more electrodes connected to an appropriate power source to provide the electric charge. In an embodiment, the local traps enabled by the particle localization structure 540, 640 are turned off and the particles are displaced to the substrate using the charge (such as a charge provided by one or more electrodes of the particle localization structure).

In an embodiment, to help achieve desired placement specifications in, for example, the Angstrom regime (0.1 - 0.9 nm) and/or to allow extra space between the traps and the substrate, optics can be used to convey the particles to the substrate. In an embodiment, the particle conveyance apparatus 550 comprises charged particle optics 550, 650. For example, an electrostatic lens known in the art, such as used in electron beam apparatuses, can be used. For example, the charged particle optics comprises an Einzel lens.

In an embodiment, particles are imaged onto the substrate with a de-magnification, particularly where, for example, the confinement using the particle localization structure 540, 640 is not in the desired placement specification. In an embodiment, the de-magnification is provided by charged particle optics. Thus, the local traps enabled by the particle localization structure 540, 640 are turned off and the particles are displaced to the substrate using the charged particle optics while the positioning of the particles is demagnified. In an embodiment, the charged particles are accelerated towards the charged particle optics. For example, a de-magnification selected from the range of 2-10000x, or from the range of 2-1000x or from the range of 2-100x (or any range selected from the range of 2-10000x) may be applied.

In an embodiment, where, for example in the application of deposition of a plurality of single particles or of clusters of particles in a pattern or to a small or narrow area, the optics are designed such that the landing energy of the particles at the substrate is almost zero (but not entirely, in the order of 0.2-1000 meV). This low landing energy helps ensure the particles 'soft-land' on the surface, stay in place and do not scatter off their respective locations. In an embodiment, the landing energies should be lower than the migration energy of the particle over the surface. In an embodiment, the landing energy is less than or equal to that at approximately room temperature (k_{b}T ~ 25 meV), which can help ensure the particles stay in place. The low landing energy may result in significant aberrations in standard charge particle optics (e.g., chromatic and/or spherical aberrations). Accordingly, in an embodiment, the energy spread in the lateral direction (e.g., parallel to the substrate surface) can be reduced by localizing the particle before it enters the charged particle optics in order to reduce the aberrations. Thus, control of the energy spread of the particles and/or strong localization of the particles can enable reduced chromatic and/or spherical aberrations. Using the cooling described herein, the energy spread can be reduced and can also facilitate the localization using the traps and particle localization structure.

As would be appreciated, the apparatus to provide the functions described with respect to 510, 520, 530, 540 and 550 can be combined in one apparatus or a combination of two or more different apparatuses by having, e.g., a trap arrangement with one or more lasers that shine into the traps to provide cooling and configured to change RF-amplitude and frequency parameters of the electrodes in time to provide the initial trapping as well as the localization. Thus, the apparatus to provide 510, 520, 530, 540 and 550 can have any type of physical construction or arrangement to provide those functions (e.g., they may all be integrated into a same apparatus, two or more functions integrated into one apparatus while one or more other functions are provided by a different apparatus, etc.). All of the apparatus 500 can be provided within a housing or chamber, which is typically arranged to be at low pressure. In an embodiment, one or more parts of the apparatus 500 can be provided outside of the housing or chamber. For example, in an embodiment, source 510 can be separate from the apparatus for 520, 530, 540 and 550 and then particles can be fed via a passage into the system corresponding to the apparatus 520, 530, 540 and 550. One or more actuators can be provided to provide relative movement between the substrate W and the traps and/or optics, usually movement of the substrate W.

In an embodiment, the transfer of one or more particles associated with a trap are individually controlled in terms of whether those one or more particles are transferred, or not, to a substrate for the purpose of, e.g., forming a pattern or providing particles to a small or narrow area. That is, a single trap effectively corresponds to a "pixel" at the substrate. In an embodiment, the transfer of one or more particles associated with a plurality of traps are collectively controlled in terms of whether those one or more particles from those plurality of traps are transferred, or not, to a substrate for the purpose of, e.g., forming a pattern or providing particles to a small or narrow area. That is, a plurality of traps effectively correspond to a "pixel" at the substrate. This type of arrangement can be easier to implement (control of the transfer of particles from a plurality of traps instead of a single trap) at possible expense of resolution fineness. In this type of arrangement, there can be, for example, a plurality of collections (e.g. arrays) of traps (comparable to those shown in Figure 3A and Figure 8, with whatever appropriate number of traps) with transfer of particles to the substrate from each such collection being individually controlled. In an embodiment, there can be a combination of these types of arrangements - control of transfer of particles to the substrate from different collections of a plurality of traps for "coarse" resolution and control of transfer of particles to the substrate from individual traps for "fine" resolution.

In an embodiment, the pattern transfer apparatuses described herein are able to form a pattern of transferred particles, such as at least part of device such as an integrated circuit. In an embodiment, the pattern transfer apparatuses described herein structure are able to transfer particles to a small or narrow area at a specific accurate location, whether those particles form a pattern or not. In an embodiment, a small area on the substrate is an area of less than or equal to 1 mm², less than or equal to 0.5 mm², less than or equal to 0.1 mm², less than or equal to 1 micron², less than or equal to 100 nm², or less than or equal to 10 nm² (or any other range selected from the range of less than or equal to 1 mm² or selected from the range of less than or equal 1 micron²). In an embodiment, a narrow area on the substrate is an area having a cross-sectional dimension (e.g., width) of less than or equal to 10 nm, or less than or equal to 5 nm, or less than or equal to 1 nm, or less than or equal to 0.5 nm (or any other range selected from the range of less than or equal to 10 nm). In an embodiment, a specific location is a location of within 10 nm or less from a desired location, at 5 nm or less from a desired location, or at 1 nm or less from a desired location, or at 0.5 nm or less from a desired location (or any other range selected from the range of 10 nm or less from a desired location).

In an embodiment, each trap is arranged to hold a single particle but can, depending on the application, hold more than one particle. In an embodiment, the particle is an atom, but in an embodiment, the particle is a molecule. As discussed herein, in an embodiment, the particles are neutral at least at some point. In an embodiment, the particles are charged at least at some point. In an embodiment, each particle in a trap could be separately transferred to the substrate and as discussed herein, the transfer of the separate particles can be individually controlled and/or a collection of particles from different traps can be collectively transferred to the substrate. So, similarly, wherein each trap has more than one particle, the transfer of the particles from each of the separate traps can be individually controlled and/or a collection of particles from different traps, each having more than one particle, can be collectively transferred to the substrate. Of course, there can be a combination of the control of the transfer of individual particles with control of the transfer of a plurality of particles collectively.

In a non-limiting embodiment, the system can have 100,000,000 (e.g., 10,000 × 10,000) traps, working essentially in parallel with a frequency of around 50 kHz, so that the system can transfer particles with 0.5 nm or better accuracy at a throughput of 16h for a full standard 300 mm semiconductor substrate. Of course, use of larger clusters than single particles can increase throughput. Further, if only selected parts of the substrate require particles, then throughput can be increased.

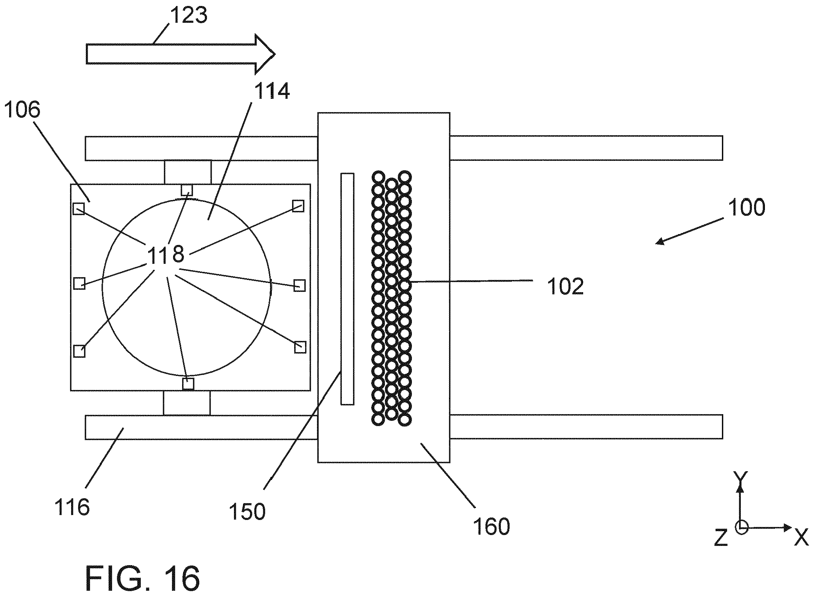

Figure 16 depicts a schematic top view of a part of a particle transfer apparatus according to an embodiment for use with substrates (e.g., 300 mm wafers). As shown in Figure 16, the apparatus 100 comprises a substrate table 106 to hold a substrate 114. Associated with the substrate table 106 is a positioning device 116 to move the substrate table 106 in at least the X-direction as shown by arrow 123 (of course the substrate table 106 can move in the opposite way shown by arrow 123). Optionally, the positioning device 116 may move the substrate table 106 in the Y-direction and/or Z-direction. The positioning device 116 may also rotate the substrate table 106 about the X-, Y- and/or Z-directions. Accordingly, the positioning device 116 may provide motion in up to 6 degrees of freedom. In an embodiment, the substrate table 106 provides motion only in the X-direction, an advantage of which is lower costs and less complexity.

The apparatus 100 further comprises a plurality of individually addressable elements 102 arranged on a frame 160. Frame 160 may be mechanically isolated from the substrate table 106 and its positioning device 116. Mechanical isolation may be provided, for example, by connecting the frame 160 to ground or a firm base separately from the frame for the substrate table 106 and/or its positioning device 116. In addition or alternatively, dampers may be provided between frame 160 and the structure to which it is connected, whether that structure is ground, a firm base or a frame supporting the substrate table 106 and/or its positioning device 116.

In this embodiment, each of the individually addressable elements 102 is one of the traps described above or a collection of traps as described above. For the sake of simplicity, three rows of individually addressable elements 102 extending along the Y-direction (and spaced in the X-direction) are shown in Figure 16, each row having, in this embodiment, sufficient columns to extend across the width of the substrate; a different number of rows and/or columns of individually addressable elements 102 may be arranged on the frame 160. For example, the number of columns need not extend across the width of the substrate. In an embodiment, each of the individually addressable elements 102 corresponds to a single trap. In an embodiment, each of the individually addressable elements 102 corresponds to a plurality of traps (e.g., arranged in a regular array). In an embodiment, one or more rows of individually addressable elements 102 are staggered in the Y-direction from an adjacent row of individually addressable elements 102 as shown in Figure 16. In an embodiment, the individually addressable elements 102 are substantially stationary, i.e., they do not move significantly or at all during particle transfer.

The apparatus 100, particularly the individually addressable elements 102, may be arranged to provide pixel-grid transfer as described in more detail herein. However, in an embodiment, the apparatus 100 need not provide pixel-grid transfer.

Element 150 of apparatus 100 as depicted in Figure 16 may comprise a measurement system. Such a measurement system may e.g. comprise an alignment sensor, a level sensor, or both. For example, in an embodiment, the apparatus 100 comprises an alignment sensor 150. The alignment sensor is used to determine alignment between the substrate 114 and, for example, the individually addressable elements 102 before and/or during transfer of particles to the substrate 114. In an embodiment, the alignment sensor 150 is configured to measure an alignment mark (e.g., P1 or P2 in Figure 1) on the substrate 114 and/or an alignment mark (e.g., one or more alignment marks 118) on the table 106. The results of the alignment sensor 150 can be used by a controller of the apparatus 100 to control, for example, the positioning device 116 to position the substrate table 106 to improve alignment. In addition or alternatively, the controller may control, for example, responsive to a signal from sensor 150, a positioning device associated with the individually addressable elements 102 to position one or more of the individually addressable elements 102 (including, for example, positioning one or more of the elements 102 relative to one or more other elements 102) to improve alignment. In an embodiment, the alignment sensor 150 may include pattern recognition functionality/software to perform alignment.

In an embodiment, the apparatus 100, in addition or alternatively, comprises a level sensor 150. The level sensor 150 is used to determine whether the substrate 114 is level with respect to the transfer of the particles from the individually addressable elements 102. The level sensor 150 can determine level before and/or during transfer of the particles to the substrate 114. The results of the level sensor 150 can be used by a controller of the apparatus 100 to control, for example, the positioning device 116 to position the substrate table 106 to improve levelling. In addition or alternatively, the controller may control, for example, responsive to a signal from sensor 150, a positioning device associated with the individually addressable elements 102 (e.g., a frame supporting at least part of an individually addressable element 102) to position at least part of an individually addressable elements 102 to improve levelling. In an embodiment, the level sensor may operate by projecting an electromagnetic beam of radiation at the substrate 114.

In an embodiment, results from the alignment sensor and/or the level sensor may be used to alter the pattern provided by the individually addressable elements 102. The pattern may be altered to correct, for example, distortion, which may arise from, e.g., optics (if any) between the individually addressable elements 102 and the substrate 114, irregularities in the positioning of the substrate 114, unevenness of the substrate 114, etc. Thus, results from the alignment sensor and/or the level sensor can be used to alter the pattern to cause a non-linear distortion correction.

In operation of the apparatus 100, a substrate 114 is loaded onto the substrate table 106 using, for example, a robot handler (not shown). The substrate 114 is then displaced in the X-direction as shown in the arrow 123 under the frame 160 and the individually addressable elements 102. The substrate 114 is measured by the level sensor and/or the alignment sensor 150 and then is exposed to the particles from the individually addressable elements 102. For example, the substrate 114 is moved (e.g., stepped) through the focal plane (image plane) of the individually addressable elements 102 and the individually addressable elements 102 are effectively switched to at least partially or fully "ON" to transfer particles or "OFF" to not transfer particles. Features corresponding to the desired pattern or layout are formed on the substrate 114.

In an embodiment, the substrate 114 may be moved (e.g., stepped) completely in the positive X-direction and then moved (e.g., stepped) completely in the negative X-direction. In such an embodiment, an additional level sensor and/or alignment sensor 150 on the opposite side of the individually addressable elements 102 may be required for the negative X-direction movement.

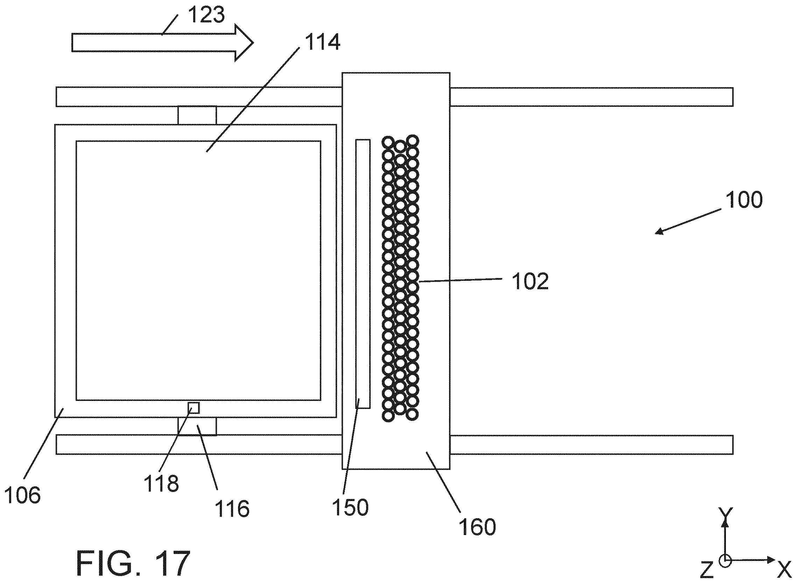

Figure 17 depicts a schematic top view of a part of an apparatus according to an embodiment for transferring particles to substrates in the manufacture of, for instance, flat panel devices (e.g., LCDs, OLED displays, etc.). Like the apparatus 100 shown in Figure 16, the apparatus 100 comprises a substrate table 106 to hold a flat panel substrate 114, a positioning device 116 to move the substrate table 106 in up to 6 degrees of freedom, an alignment sensor 150 to determine alignment between the individually addressable elements 102 and the substrate 114, and a level sensor 150 to determine whether the substrate 114 is level with respect to the transfer of particles.

The apparatus 100 further comprises a plurality of individually addressable elements 102 arranged on a frame 160. In this embodiment, each of the individually addressable elements 102 is one of the traps described above or a collection of traps as described above. For the sake of simplicity, three rows of individually addressable elements 102 extending along the Y-direction are shown in Figure 17 and having sufficient columns to cover the width of the substrate; a different number of rows and/or columns of individually addressable elements 102 may be arranged on the frame 160. For example, the number of columns need not extend across the width of the substrate. In an embodiment, each of the individually addressable elements 102 corresponds to a single trap. In an embodiment, each of the individually addressable elements 102 corresponds to a plurality of traps (e.g., arranged in a regular array). In an embodiment, one or more rows of individually addressable elements 102 are staggered in the Y-direction from an adjacent row of individually addressable elements 102 as shown in Figure 17. In an embodiment, the individually addressable elements 102 are substantially stationary, i.e., they do not move significantly or at all during particle transfer.

In operation of the apparatus 100, a panel substrate 114 is loaded onto the substrate table 106 using, for example, a robot handler (not shown). The substrate 114 is then displaced in the X-direction as shown in arrow 123 under the frame 160 and the individually addressable elements 102. The substrate 114 is measured by the level sensor and/or the alignment sensor 150 and then is exposed to the particles from individually addressable elements 102. One or more lenses may be used to convey the particles to the substrate.

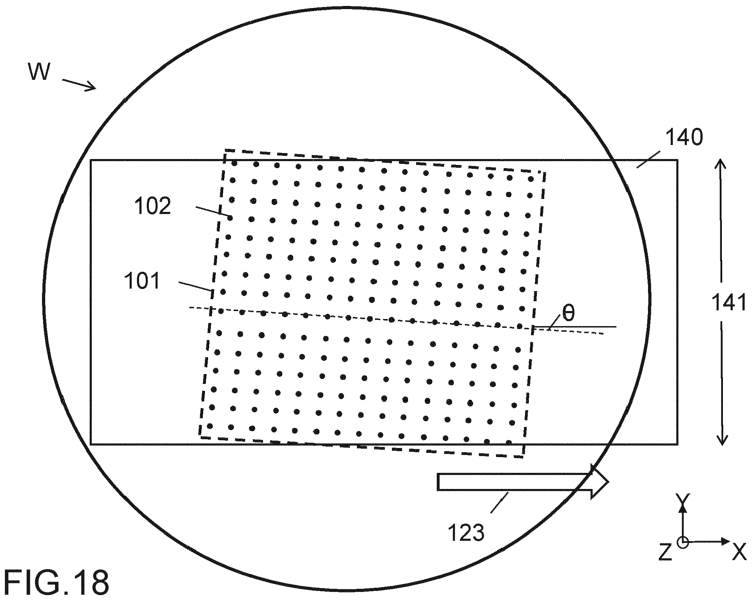

Referring to Figure 18, a highly schematic top view of an arrangement of individually addressable elements 102 is depicted in relation to a substrate W. The Figure is by no means to scale - for example, the substrate W would typically be much larger. As seen, there are a plurality of individually addressable elements 102 arranged, in this embodiment, in a two-dimensional arrangement (e.g., array) 101. In Figure 18, there are 225 individually addressable elements 102 arranged in a square 15x15 array; of course, there can be a different number, arranged in a different type of array, etc. Each individually addressable element 102 emits one or more particles toward the substrate 114, thereby generating a spot where one or more particles are transferred to on the substrate 114. As shown in Figure 18, the array 101 is situated at an angle θ relative to the direction 123 of relative movement between the substrate 114 and the individually addressable elements 102 (e.g., the direction 123 of movement of the substrate 114). This is so that, when there is relative movement between the substrate 114 and the individually addressable elements 102 in this direction, each spot effectively passes over a different area of the substrate (although there can be some overlap), thereby enabling production of a brush 140 of transferred particles having a width 141. In an embodiment, the width 141 corresponds to a width of a target portion on the substrate W. In an embodiment, a target portion corresponds to a portion diced along a scribe lane from a substrate. In an embodiment, the angle θ is at most 20°, 10°, for instance at most 5°, at most 3°, at most 1°, at most 0.5°, at most 0.25°, at most 0.10°, at most 0.05°, or at most 0.01°. In an embodiment, the angle θ is at least 0.0001°, e.g. at least 0.001°. The angle of inclination θ is determined in accordance with the spot size (which can be a function of working distance between the substrate and the individually addressable elements 102) and the pitch between adjacent individually addressable elements 102. This angle effectively enables the inherent pitch between traps to be narrowed.

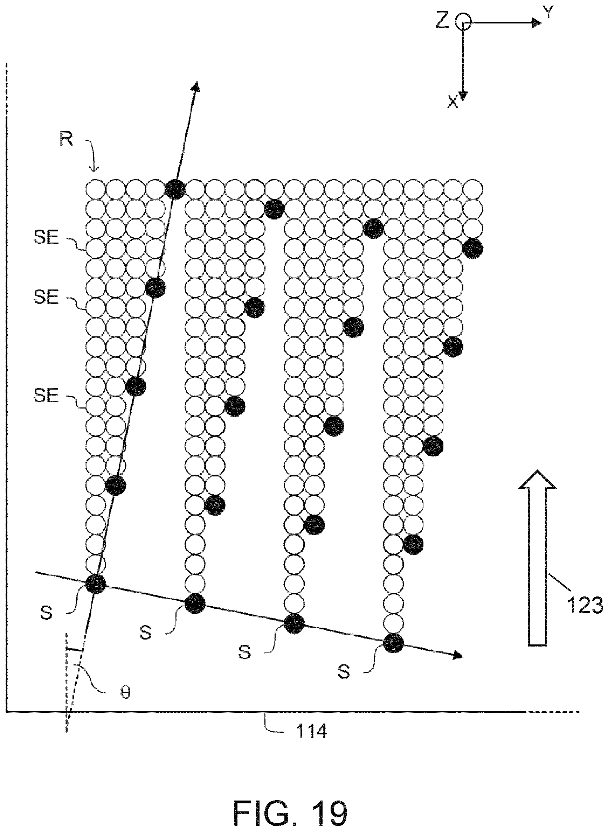

Figure 19 illustrates schematically a top view of how a pattern or other layout on the substrate 114 may be generated. The filled in circles represent the array of spots S of particles transferred onto the substrate 114 by individually addressable elements 102 in the array 101. The substrate 114 is moved relative to the individually addressable elements 102 in the X-direction (e.g., in the direction 123) as, for example, a series of transfers are made on the substrate 114. The open circles represent spots SE that have previously been processed by either transfer of one or more particles to the spot on the substrate 114 or no transfer of a particle to the spot on the substrate 114. As shown, each spot associated with each individually addressable element 102 in the array 101 transfers particles to a column R of spots on the substrate 114. The complete pattern for the substrate 114 is generated by the sum of all the columns R of spots associated with all the individually addressable elements 102. Such an arrangement can be referred to as "pixel-grid transfer." It will be appreciated that Figure 19 is a schematic drawing and that spots S and/or spots SE may overlap in practice.

Similar to that shown in Figure 18, the array of spots S is arranged at an angle θ relative to the relative movement direction 123. This is done so that, when there is relative movement between the substrate 114 and the individually addressable elements 102 in that direction, each spot will effectively pass over a different area of the substrate 114, thereby allowing for producing a brush in a single scan. As discussed above, the angle of inclination θ is determined in accordance with the spot size, the pitch between adjacent spots, etc.

Various embodiments may be employed to write patterns to cover the substrate 114 by using one or more arrays 101. Of course, in an embodiment, the array or arrays 101 are not at an angle to the relative motion and so, there can be various motions in the relative motion direction and in a direction orthogonal thereto to transfer particles to various desired locations. In an embodiment, a plurality of arrays 101 are provided along the motion direction but that are situated at an offset in a direction orthogonal to the relative motion direction, thus the second, third, etc. array 101 fills gaps left by a first array 101. A single relative motion across a target portion of a substrate may be sufficient to process the target portion (e.g., a portion of the substrate that will be diced from the substrate) or multiple relative motions (perhaps including orthogonal motions) may be used to process the target portion. Then, further motions (e.g., meandering motions) would be used to process other target portions or there can be multiple arrays 101 that act in parallel to improve throughput. Or a single relative motion across the substrate may be sufficient to process the entire substrate or multiple relative motions (perhaps including orthogonal motions) may be used to process an entire substrate.

Similarly, in respect of the brush 140, in an embodiment, array 101 is large enough to fully expose the width of the brush 140. If array 101 is not large enough to fully expose the width of the brush 140 in a single scan, various embodiments can be used to fully cover the brush 140 width. In an embodiment, there is provided relative movement between the array 101 and the substrate multiple times while in between these movements a small relative motion is made in a direction orthogonal to that movement direction to "fill" in the gaps. In an embodiment, a plurality of arrays 101 is provided along the motion direction but that are situated at an offset in a direction orthogonal to that motion direction, thus the second, third, etc. array 101 fills the gaps left by a first array 101. A single relative motion between the brush 140 and a target portion of a substrate may be sufficient to process the target portion (e.g., a portion of the substrate that will be diced from the substrate) or multiple relative motions (perhaps including orthogonal motions) may be used to process the target portion. Then, further motions (e.g., meandering motions) would be used to process other target portions or there can be multiple brushes 140 that act in parallel to improve throughput. Or a single relative motion between the brush 140 and the substrate may be sufficient to process the entire substrate or multiple relative motions (perhaps including orthogonal motions) may be used to process an entire substrate.

Redundancy (e.g., using another individually addressable element to process an area of an individually addressable element 102 that fails or doesn't work properly) can be implemented. This can be done, e.g., by enlarging the motion range and/or adding one or more extra individually addressable elements 102.

In an embodiment, the substrate herein can include any structure onto which particles are desired to be transferred. One non-limiting embodiment is a substrate (e.g., a silicon wafer) for forming devices or on which devices have or are partially formed. The particles can be transferred onto such a substrate for deposition, etch, implantation, device structure formation, etc. Another non-limiting embodiment is a substrate corresponding to a mask or reticle used for photolithography or imprint lithography. The particles can be transferred onto such a substrate for deposition, etch, implantation, mask / reticle structure formation, etc. In an embodiment, the techniques herein can be used for repair of an object. For example, the particles can be transferred onto a substrate corresponding to a mask or reticle for repair of a mask / reticle structure. Similarly, techniques can be used to repair a device formed on a substrate.

So, there is provided a pattern transfer apparatus that is able to place particles at specific locations, e.g., at precise locations in areas significantly smaller than entire substrate. In an embodiment, the placement of the particles can be for various applications, such as etching, or implanting, or feature building (akin to traditional optical lithography but instead of optically exposing resist to form features of, e.g., a device, the deposited particles are used to form features).

In an embodiment, a pattern transfer apparatus and method can transfer particles to specific locations in a deterministic and parallel manner. In a general manner, a pattern transfer apparatus and method can involve specific placement of particles (e.g., atoms, molecules) onto a substrate, for example, for structure building (comparable to traditional litho patterning) of devices, mask features, etc.), for highly localized implantation (rather than blanket implantation on a substrate), for highly localized etching (rather than blanket etching on a substrate), etc.

This can enable operating at atom / molecule scale. Photolithography on this scale may be difficult due to large dimensions of the resist molecules and limitations of electromagnetic radiation. A scanning probe can be hard to scale-up (massive amounts of parallel tips, but cumbersome to control). And other deposition may not provide spatial atomic resolution.

So, in an embodiment, there is provided a scalable system to transfer particles (e.g., atoms, ions, etc.) onto a substrate with desirably sub-NM accuracy. In general to achieve the transfer, the particles are cooled (such that they have ultra-low energy spread) and confined / localized using a plurality of traps. A particle conveyance structure (e.g., electron-optics) is used to convey the particles from the traps in parallel to the substrate with high accuracy. In an embodiment, a particle source generates a particle stream for subsequent trapping. In an embodiment, the particles are cooled down sufficiently so that the atoms can be trapped by a trap. Cooling can be done in various stages, usually starting with laser cooling (Doppler cooling) In an embodiment, the trap confines many particles in a volume. In an embodiment, the particles are individually trapped in a two-dimensional arrangement so that they can be conveyed in parallel to the substrate in order meet throughput. Typical traps for neutral atoms are magneto-optical traps. Optionally a 2D trap is created using a strong laser. For charged particles, Paul traps or a wire grid array trap can be used. The cooling and trapping can be repeated, i.e., particles continually cooled while being trapped. In an embodiment, the particles are further locally trapped using, e.g., optical tweezers or a configuration of a Paul / wire grid array trap. This is to enable desired accuracy. Optionally, the particles are charged (e.g. using laser light) in order to use, for example, charged particle optics. In an embodiment, a particle conveyance structure (e.g., electron-optics) is then used deposit the particles in parallel on the substrate with high accuracy. For structure building, the landing energy is desirably close to zero so the particles remain in place. For implantation and etching applications, the landing energy can be (much) higher.

Embodiments are provided according to the following numbered clauses:
1. A particle transfer system, comprising:
   a particle trap apparatus configured to trap a plurality of particles; and
   a particle conveyance structure configured to convey the particles in parallel from the particle trap apparatus to a substrate.
2. The system of clause 1, further comprising a particle source configured to provide a stream or cloud of particles to the particle trap apparatus.
3. The system of clause 2, wherein the particles are neutral.
4. The system of clause 2, wherein the particles are charged.
5. The system of any of clauses 1 to 4, wherein the particle trap apparatus forms a plurality of traps, each trap configured to hold one or more particles.
6. The system of clause 5, wherein the particle trap apparatus comprises one or more lasers configured to illuminate the particles to form the traps.
7. The system of clause 5, wherein the particle trap apparatus comprises one or more electrodes configured to generate electric fields to form the traps.
8. The system of any of clauses 1 to 7, further comprising a particle cooling apparatus to cool the particles.
9. The system of clause 8, wherein the particle cooling apparatus comprises one or more lasers configured to illuminate the particles to cool them.
10. The system of any of clauses 1 to 9, wherein the particle conveyance structure comprises charged particle optics.
11. The system of any of clauses 1 to 10, wherein the particle conveyance structure is configured to provide de-magnification.
12. The system of clause 11, wherein the demagnification is selected from the range of 2-1000x.
13. The system of any of clauses 1 to 12, further comprising a particle localization structure configured to provide localization of trapped particles of the particle trap apparatus.
14. The system of clause 13, wherein the particle localization structure comprises one or more lasers configured to provide laser spots in a two-dimensional plane.
15. The system of clause 14, wherein the laser spots are created using a DMD or SLM.
16. The system of clause 13, wherein the particle localization comprises one or more electrodes to provide localization of trapped particles of the particle trap apparatus.
17. The system of clause 16, wherein particle localization structure is configured to provide a confinement potential configured to only allow a single particle in a region defined by the one or more electrodes.
18. The system of clause 16 or clause 17, wherein the particle localization structure is configured to provide a confinement potential to locate a position of a particle to within 100 nm of a desired location.
19. The system of any of clauses 16 to 18, wherein the one or more electrodes form a grid array of apertures into which a respective electric field is provided.
20. The system of any of clauses 16 to 19, wherein the one or more electrodes comprise at least two overlapping, comb-shaped electrodes.
21. The system of any of clauses 1 to 20, further comprising a particle charge apparatus configured to charge the particles.
22. The system of clause 21, wherein the particle charge apparatus comprises a laser to irradiate the particles to ionize them.
23. The system of any of clauses 1 to 22, configured to etch the substrate with the particles.
24. The system of any of clauses 1 to 22, configured to implant the particles into a surface of the substrate.
25. The system of any of clauses 1 to 22, configured to build a structure by deposition of the particles on a surface of the substrate.
26. A patterning system for generating a pattern on a substrate, the system comprising:
   a particle trap apparatus configured to trap a plurality of particles in a spatial arrangement; and
   a particle conveyance structure configured to convey the particles in the form of a pattern from the particle trap apparatus to the substrate.
27. The system of clause 26, further comprising a particle source configured to provide a stream or cloud of particles to the particle trap apparatus.
28. The system of clause 27, wherein the particles are neutral.
29. The system of clause 27, wherein the particles are charged.
30. The system of any of clauses 26 to 29, wherein the particle trap apparatus forms a plurality of traps, each trap configured to hold one or more particles.
31. The system of clause 30, wherein the particle trap apparatus comprises one or more lasers configured to illuminate the particles to form the traps.
32. The system of clause 30, wherein the particle trap apparatus comprises one or more electrodes configured to generate electric fields to form the traps.
33. The system of any of clauses 26 to 32, further comprising a particle cooling apparatus to cool the particles.
34. The system of clause 33, wherein the particle cooling apparatus comprises one or more lasers configured to illuminate the particles to cool them.
35. The system of any of clauses 26 to 34, wherein the particle conveyance structure comprises charged particle optics.
36. The system of any of clauses 26 to 35, wherein the particle conveyance structure is configured to provide de-magnification.
37. The system of clause 36, wherein the demagnification is selected from the range of 2-1000x.
38. The system of any of clauses 26 to 37, further comprising a particle localization structure configured to provide localization of trapped particles of the particle trap apparatus.
39. The system of clause 38, wherein the particle localization structure comprises one or more lasers configured to provide laser spots in a two-dimensional plane.
40. The system of clause 39, wherein the laser spots are created using a DMD or SLM.
41. The system of clause 38, wherein the particle localization comprises one or more electrodes to provide localization of trapped particles of the particle trap apparatus.
42. The system of clause 41, wherein particle localization structure is configured to provide a confinement potential configured to only allow a single particle in a region defined by the one or more electrodes.
43. The system of clause 41 or clause 42, wherein the particle localization structure is configured to provide a confinement potential to locate a position of a particle to within 100 nm of a desired location.
44. The system of any of clauses 41 to 43, wherein the one or more electrodes form a grid array of apertures into which a respective electric field is provided.
45. The system of any of clauses 41 to 44, wherein the one or more electrodes comprise at least two overlapping, comb-shaped electrodes.
46. The system of any of clauses 26 to 45, further comprising a particle charge apparatus configured to charge the particles.
47. The system of clause 46, wherein the particle charge apparatus comprises a laser to irradiate the particles to ionize them.
48. The system of any of clauses 26 to 47, configured to etch the substrate with the particles.
49. The system of any of clauses 26 to 47, configured to implant the particles into a surface of the substrate.
50. The system of any of clauses 26 to 47, configured to build a structure by deposition of the particles on a surface of the substrate.
51. A particle transfer system, comprising:
   a particle source configured to provide particles;
   a particle cooling apparatus configured to cool the particles;
   a particle trap apparatus configured to illuminate a plurality of spatial locations to locally trap single particles; and
   a particle conveyance apparatus configured to convey the charged particles to a substrate surface.
52. The system of clause 51, wherein the particles are neutral.
53. The system of clause 51 or clause 52, further comprising a particle charge apparatus configured to provide a charge to particles that are, or were, trapped.
54. The system of any of clauses 51 to 53, wherein the particle trap apparatus forms a plurality of traps, each trap configured to hold one or more particles.
55. The system of clause 54, wherein the particle trap apparatus comprises one or more lasers configured to illuminate the particles to form the traps.
56. The system of any of clauses 51 to 55, wherein the particle cooling apparatus comprises one or more lasers configured to illuminate the particles to cool them.
57. The system of any of clauses 51 to 56, wherein the particle conveyance structure comprises charged particle optics.
58. The system of any of clauses 51 to 57, wherein the particle conveyance structure is configured to provide de-magnification.
59. The system of clause 58, wherein the demagnification is selected from the range of 2-1000x.
60. The system of any of clauses 51 to 59, wherein the particle trap apparatus comprises one or more lasers configured to provide laser spots in a two-dimensional plane.
61. The system of clause 60, wherein the laser spots are created using a DMD or SLM.
62. The system of any of clauses 51 to 61, configured to etch the substrate with the particles.
63. The system of any of clauses 51 to 61, configured to implant the particles into a surface of the substrate.
64. The system of any of clauses 51 to 61, configured to build a structure by deposition of the particles on a surface of the substrate.
65. A particle transfer system, comprising:
   a particle source configured to provide particles;
   a particle trap apparatus configured to generate a plurality of electric fields, each field at different spatial location and each field configured to locally trap a single particle;
   a particle cooling apparatus configured to cool the particles; and
   a particle conveyance apparatus configured to convey the charged particles to a substrate surface.
66. The system of clause 66, wherein the particles are charged.
67. The system of clause 65 or clause 66, wherein the particle trap apparatus comprises a plurality of electrodes configured to generate the electric fields to form a plurality of traps.
68. The system of any of clauses 65 to 67, wherein the particle cooling apparatus comprises one or more lasers configured to illuminate the particles to cool them.
69. The system of any of clauses 65 to 68, wherein the particle conveyance structure comprises charged particle optics.
70. The system of any of clauses 65 to 69, wherein the particle conveyance structure is configured to provide de-magnification.
71. The system of clause 70, wherein the demagnification is selected from the range of 2-1000x.
72. The system of any of clauses 65 to 71, wherein the particle trap apparatus is configured to cause one or more electrodes to provide localization of already trapped particles.
73. The system of any of clauses 65 to 72, wherein particle trap apparatus is configured to provide a confinement potential configured to only allow the single particle in the respective electric field.
74. The system of any of clauses 65 to 73, wherein the particle trap apparatus is configured to provide a confinement potential to locate a position of a particle to within 100 nm of a desired location.
75. The system of any of clauses 65 to 74, wherein the particle trap apparatus comprising one or more electrodes forming a grid array of apertures into which a respective electric field is provided.
76. The system of clause 75, wherein the one or more electrodes comprise at least two overlapping, comb-shaped electrodes.
77. The system of any of clauses 65 to 76, configured to etch the substrate with the particles.
78. The system of any of clauses 65 to 76, configured to implant the particles into a surface of the substrate.
79. The system of any of clauses 65 to 76, configured to build a structure by deposition of the particles on a surface of the substrate.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens," where the context allows, may refer to any one or combination of various types of optical components, including refractive, reflective, magnetic, electromagnetic and electrostatic optical components.

An embodiment of the disclosure may take the form of a computer program containing one or more sequences of machine-readable instructions causing execution of a method, or a sub-step of a larger method, as disclosed herein, or a data storage medium (e.g. semiconductor memory, magnetic or optical disk) having such a computer program stored therein. As will be appreciated, the instructions are executed by one or more processors or a computer system (which can include a network of computers). Further, the machine-readable instruction may be embodied in two or more computer programs. The two or more computer programs may be stored on one or more different memories and/or data storage media.

Any controllers or control units described herein may be hardwired to cause execution of an applicable method, or an applicable sub-step of a larger method, as disclosed herein. Any controllers or control units described herein may each or in combination be operable when one or more computer programs are read by one or more computer processors located within at least one component of an apparatus. The controllers or control units may each or in combination have any suitable configuration for receiving, processing, and sending signals. One or more processors are configured to communicate with the at least one of the controllers or control units. For example, each controller or control unit may include one or more processors for executing computer programs that include machine-readable instructions for the methods or sub-steps described above. The controllers or control units may include data storage medium for storing such computer programs, and/or hardware to receive such a medium or one or more programs. So the controller(s) or control unit(s) may operate according to the machine-readable instructions of one or more computer programs.

Although specific reference may be made in this text to the use of processes and apparatuses in the context of IC manufacture, the apparatuses and processes described herein may have other applications, such as the manufacture or repair of integrated optical systems, guidance and detection patterns for magnetic domain memories, flat-panel displays, liquid-crystal displays (LCDs), thin film magnetic heads, masks / reticles for photolithography or imprint lithography, etc. The skilled artisan will appreciate that, in the context of such alternative applications, any use of the terms "wafer" or "die" herein may be considered as synonymous with the more general terms "substrate" or "target portion", respectively. As noted above, the substrate referred to herein may be processed, before or after patterning, in for example a track (a tool that typically applies a layer of resist to a substrate and develops the exposed resist), a metrology tool and/or one or more various other tools. The disclosure herein may be applied to such and other substrate processing tools. Further, the substrate may be processed more than once, for example in order to create a multi-layer device, so that the term substrate used herein may also refer to a substrate that already contains multiple processed layers.

References herein to crossing or passing a threshold may include something having a value lower than a specific value or lower than or equal to a specific value, something having a value higher than a specific value or higher than or equal to a specific value, something being ranked higher or lower than something else (through e.g., sorting) based on, e.g., a parameter, etc.

References herein to correcting or corrections of an error include eliminating the error or reducing the error to within a tolerance range.

The term "optimizing" and "optimization" if used herein refers to or means adjusting a patterning apparatus, a patterning process, a manufacturing apparatus, etc. such that results and/or processes of patterning or other related processing have more a desirable characteristic, such as higher accuracy of application of a design layout on a substrate, a larger process window, etc. Thus, the term "optimizing" and "optimization" as used herein refers to or means a process that identifies one or more values for one or more variables that provide an improvement, e.g. a local optimum, in at least one relevant metric, compared to an initial set of one or more values for those one or more variables. "Optimum" and other related terms should be construed accordingly. In an embodiment, optimization steps can be applied iteratively to provide further improvements in one or more metrics.

In an optimization process of a system, a figure of merit of the system or process can be represented as a cost function. The optimization process boils down to a process of finding a set of parameters (design variables) of the system or process that optimizes (e.g., minimizes or maximizes) the cost function. The cost function can have any suitable form depending on the goal of the optimization. For example, the cost function can be weighted root mean square (RMS) of deviations of certain characteristics (evaluation points) of the system or process with respect to the intended values (e.g., ideal values) of these characteristics; the cost function can also be the maximum of these deviations (i.e., worst deviation). The term "evaluation points" herein should be interpreted broadly to include any characteristics of the system or process. The design variables of the system can be confined to finite ranges and/or be interdependent due to practicalities of implementations of the system or process. In the case of a patterning apparatus or patterning process, the constraints are often associated with physical properties and characteristics of the hardware such as tunable ranges, and/or manufacturability design rules, and the evaluation points can include parameters representing physical characteristics on a substrate (e.g., critical dimension, overlay, etc.), as well as non-physical characteristics such focus, magnification, etc.

In block diagrams, illustrated components are depicted as discrete functional blocks, but embodiments are not limited to systems in which the functionality described herein is organized as illustrated. The functionality provided by each of the components may be provided by software or hardware modules and may be differently organized than is presently depicted, for example such software or hardware may be intermingled, conjoined, replicated, broken up, distributed (e.g. within a data center or geographically), or otherwise differently organized. One or more parts of the functionality described herein may be provided by one or more processors of one or more computers executing code stored on a tangible, non-transitory, machine-readable medium. In some cases, third party content delivery networks may host some or all of the information conveyed over networks, in which case, to the extent information (e.g., content) is said to be supplied or otherwise provided, the information may be provided by sending instructions to retrieve that information from a content delivery network.

References to side, top and bottom herein are for convenience and not intended to be any type of limitation on an actual orientation of a tool. For example, in an embodiment, top, bottom and side can reference a tool that is arranged vertically. However, in an embodiment, the bottom and top can reference a tool that is arranged horizontally with a side view being a view from "above" or "below" in such a horizontal arrangement.

Unless specifically stated otherwise, as apparent from the discussion, it is appreciated that throughout this specification discussions utilizing terms such as "processing," "computing," "calculating," "determining" or the like refer to actions or processes of a specific apparatus, such as a special purpose computer or a similar special purpose electronic processing/computing device.

The reader should appreciate that the present application describes several inventions. Rather than separating those inventions into multiple isolated patent applications, applicants have grouped these inventions into a single document because their related subject matter lends itself to economies in the application process. But the distinct advantages and aspects of such inventions should not be conflated. In some cases, embodiments address all of the deficiencies noted herein, but it should be understood that the inventions are independently useful, and some embodiments address only a subset of such problems or offer other, unmentioned benefits that will be apparent to those of skill in the art reviewing the present disclosure. Due to costs constraints, some inventions disclosed herein may not be presently claimed and may be claimed in later filings, such as continuation applications or by amending the present claims. Similarly, due to space constraints, neither the Abstract nor the Summary sections of the present document should be taken as containing a comprehensive listing of all such inventions or all aspects of such inventions.

Modifications and alternative embodiments of various aspects of the invention will be apparent to those skilled in the art in view of this description. Accordingly, this description and the drawings are to be construed as illustrative only and are for the purpose of teaching those skilled in the art the general manner of carrying out the invention. It is to be understood that the forms of the invention shown and described herein are to be taken as examples of embodiments. Elements and materials may be substituted for those illustrated and described herein, parts and processes may be reversed or omitted, certain features may be utilized independently, and embodiments or features of embodiments may be combined, all as would be apparent to one skilled in the art after having the benefit of this description of the invention. Changes may be made in the elements described herein without departing from the spirit and scope of the invention as described in the following claims. Headings, if any, used herein are for organizational purposes only and are not meant to be used to limit the scope of the description.

As used throughout this application, the word "may" is used in a permissive sense (i.e., meaning having the potential to), rather than the mandatory sense (i.e., meaning must). The words "include," "including," and "includes" and the like mean including, but not limited to. As used throughout this application, the singular forms "a," "an," and "the" include plural referents unless the content explicitly indicates otherwise. Thus, for example, reference to "an" element or "a" element includes a combination of two or more elements, notwithstanding use of other terms and phrases for one or more elements, such as "one or more." The term "or" is, unless indicated otherwise, non-exclusive, i.e., encompassing both "and" and "or." Terms describing conditional relationships, e.g., "in response to X, Y," "upon X, Y,", "if X, Y," "when X, Y," and the like, encompass causal relationships in which the antecedent is a necessary causal condition, the antecedent is a sufficient causal condition, or the antecedent is a contributory causal condition of the consequent, e.g., "state X occurs upon condition Y obtaining" is generic to "X occurs solely upon Y" and "X occurs upon Y and Z." Such conditional relationships are not limited to consequences that instantly follow the antecedent obtaining, as some consequences may be delayed, and in conditional statements, antecedents are connected to their consequents, e.g., the antecedent is relevant to the likelihood of the consequent occurring. Statements in which a plurality of attributes or functions are mapped to a plurality of objects (e.g., one or more processors performing steps A, B, C, and D) encompasses both all such attributes or functions being mapped to all such objects and subsets of the attributes or functions being mapped to subsets of the attributes or functions (e.g., both all processors each performing steps A-D, and a case in which processor 1 performs step A, processor 2 performs step B and part of step C, and processor 3 performs part of step C and step D), unless otherwise indicated. Further, unless otherwise indicated, statements that one value or action is "based on" another condition or value encompass both instances in which the condition or value is the sole factor and instances in which the condition or value is one factor among a plurality of factors. Unless otherwise indicated, statements that "each" instance of some collection have some property should not be read to exclude cases where some otherwise identical or similar members of a larger collection do not have the property, i.e., each does not necessarily mean each and every.

To the extent certain U.S. patents, U.S. patent applications, or other materials (e.g., articles) have been incorporated by reference, the text of such U.S. patents, U.S. patent applications, and other materials is only incorporated by reference to the extent that no conflict exists between such material and the statements and drawings set forth herein. In the event of such conflict, any such conflicting text in such incorporated by reference U.S. patents, U.S. patent applications, and other materials is specifically not incorporated by reference herein.

The description and the drawings are not intended to limit the invention to the particular form disclosed, but to the contrary, the intention is to cover all modifications, equivalents, and alternatives falling within the spirit and scope of the present invention as defined by the appended claims. The foregoing description of the specific embodiments fully reveals the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance. The breadth and scope of the present invention should not be limited by any of the above-described exemplary embodiments, but should be defined only in accordance with the following claims and their equivalents.

## Claims

1. A patterning system for generating a pattern on a substrate, the system comprising:
a particle trap apparatus configured to trap a plurality of particles in a spatial arrangement; and
a particle conveyance structure configured to convey the particles in the form of a pattern from the particle trap apparatus to the substrate.

2. The system of claim 1, further comprising a particle source configured to provide a stream or cloud of particles to the particle trap apparatus.

3. The system of claim 2, wherein the particles are neutral.

4. The system of claim 2, wherein the particles are charged.

5. The system of claim 1, wherein the particle trap apparatus forms a plurality of traps, each trap configured to hold one or more particles.

6. The system of claim 5, wherein the particle trap apparatus comprises one or more lasers configured to illuminate the particles to form the traps.

7. The system of claim 5, wherein the particle trap apparatus comprises one or more electrodes configured to generate electric fields to form the traps.

8. The system of claim 1, further comprising a particle cooling apparatus to cool the particles.

9. The system of claim 8, wherein the particle cooling apparatus comprises one or more lasers configured to illuminate the particles to cool them.

10. The system of claim 1, wherein the particle conveyance structure comprises charged particle optics.

11. The system of claim 1, wherein the particle conveyance structure is configured to provide demagnification.

12. The system of claim 11, wherein the demagnification is selected from the range of 2-1000x.

13. The system of claim 1, further comprising a particle localization structure configured to provide localization of trapped particles of the particle trap apparatus.

14. The system of claim 13, wherein the particle localization structure comprises one or more lasers configured to provide laser spots in a two-dimensional plane, or wherein the particle localization comprises one or more electrodes to provide localization of trapped particles of the particle trap apparatus.

15. The system of any of claims 1 to 14, configured to etch the substrate with the particles, or configured to implant the particles into a surface of the substrate, or configured to build a structure by deposition of the particles on a surface of the substrate.
